# EUROPEAN PATENT APPLICATION

(11) **EP 4 029 639 A1**
(43) Date of publication of application: **20.07.2022**
(21) Application number: 20863183.8
(22) Date of filing: 04.09.2020
(51) Int. Cl.: B23K 1/00, C22C 12/00, C22C 28/00, C22C 30/04, B23K 35/26

(54) **SN-BI-IN-BASED LOW MELTING-POINT JOINING MEMBER, PRODUCTION METHOD THEREFOR, SEMICONDUCTOR ELECTRONIC CIRCUIT, AND MOUNTING METHOD THEREFOR**

(30) Priority: 11.09.2019 JP 2019165699; 11.09.2019 JP 2019165700; 11.09.2019 JP 2019165701
(71) Applicant: Shinryo Corporation, Kitakyushu-shi, Fukuoka, 806-0021 (JP)
(72) Inventor: NISHI, Hirotoshi, Kitakyushu-shi, Fukuoka 808-0109 (JP); SAWAI, Takeshi, Kitakyushu-shi, Fukuoka 806-0021 (JP); SHIROKAWA, Kenichirou, Kitakyushu-shi, Fukuoka 808-0109 (JP); OMAE, Souichirou, Kitakyushu-shi, Fukuoka 808-0109 (JP)
(74) Representative: Winter, Brandl - Partnerschaft mbB
(86) International application number: PCT/JP2020/033647
(87) International publication number: WO 2021/049437

(57) **Abstract**

Provided are a Sn-Bi-In-based low melting-point joining member used in a Pb-free electroconductive joining method in mounting a semiconductor component, and is usable for low-temperature joining, and a manufacturing method therefor.

A Sn-Bi-In-based low melting-point joining member, including a Sn-Bi-In alloy that has a composition within a range represented by a quadrangle in a Sn-Bi-In ternary phase diagram, a first quadrangle having four vertices including: Point 1 (1, 69, 30), Point 2 (26, 52, 22), Point 3 (40, 10, 50), and Point 4 (1, 25, 74), where Point (x, y, z) is defined as a point of x mass% Sn, y mass% Bi and z mass% In, and that also has a melting point of 60 to 110°C. As well as a method for producing a Sn-Bi-In-based low melting-point joining member, including a plating step of forming a plated laminate on an object to be plated, the plated laminate including a laminated plating layer obtained by performing Sn plating, Bi plating, and In plating respectively such that the laminated plating layer has a composition within the range represented by the first quadrangle.

## Description

### Technical Field

The present invention relates to a lead-free solder material for semiconductor mounting, and particularly to a Sn-Bi-In-based low melting-point joining member that can be used in a low temperature region, and a method for producing the same. Further, the present invention relates to a semiconductor electronic circuit using these and a mounting method thereof.

### Background Art

In recent years, regulations on harmful substances to the environment have become more and more strict due to RoHS regulations, etc., and solder alloys used for the purpose of joining electronic components including semiconductor chips to printed wiring boards (PWB) are also subject to regulation. Since lead (Pb) has been used as a main component of these solder components for a long time, solder alloys containing no lead (hereinafter, also referred to as Pb-free solder alloys) have been actively developed.

Conductive joining materials such as solder alloys used when joining electronic components to a printed wiring board are roughly classified into high temperature uses (about 260°C to 400°C) and medium and low temperature uses (about 140°C to 230°C) depending on the usage limit temperature. Among them, a solder alloy for low temperature uses generally refers to a solder alloy having a melting point lower than the melting point of 183°C of the eutectic alloy of Pb-63Sn.

However, recently, some of electronic components, such as flexible resin substrates and PZT (lead zirconate titanate) substrates of piezoelectric ceramics, have very low heat resistance, and their functions may be deteriorated or destroyed when exposed to high temperatures. As for the joining temperature at the time of mounting, since it is necessary to solder such electronic components at a low temperature of 135°C or less, preferably 120°C or less, and more preferably 110°C or less, a solder alloy for low temperature uses having a lower melting point is required.

Further, in integrated circuits, reduction of cost per function has been promoted by miniaturizing CMOS technology, and recently in the mounting process as well, higher integration has been promoted by integrating miniaturized chips at the package level to increase the number of chips, layers, and functions per unit area. The joining method in mounting has also been progressing from bonding wires to solder ball and solder bump joining, and there is demand for simplification and cost reduction of solder joining at the time of mounting.

Conventionally, as a Pb-free solder, Sn-3.5Ag (melting point = 221°C), Sn-0.7Cu (melting point = 227°C), Sn-Ag-Cu (melting point = 217°C), and the like have been used. However, these solder alloys each have a high melting point of 200°C or more, and it is difficult to use them at a soldering temperature of 135°C or less at the time of semiconductor mounting.

As a Pb-free low-temperature solder alloy, Patent Literature 1 describes a solder alloy for low-temperature joining composed of Sn: 37 to 47 mass%, Ag: 0.1 or more and less than 1.0 mass%, with the balance being Bi.

Patent Literature 2 describes a solder alloy composed of Sn: 40 mass%, Bi: 55 mass%, and In: 5 mass%, and a solder alloy composed of Sn: 34 mass%, Bi: 46 mass%, and In: 20 mass%. Further, a solder powder or a solder paste obtained by shaping the solder alloy into a sphere, a soldering method using these, and the like are described.

Patent Literature 3 describes a method for forming a Sn-In-Bi solder alloy plating layer, including: first plating a first layer of a tin/indium layer, then plating a second layer of a bright tin/bismuth layer on the tin/indium layer, and consecutively reflowing the first and second plating layers.

### Citation List

### Patent Literature

Patent Literature 1: Japanese Patent No. 3347512
Patent Literature 2: Japanese Patent No. 3224185
Patent Literature 3: Japanese Patent Laid-Open No. 2001-219267

### Summary of Invention

### Technical Problem

The Sn-Bi-Ag-based solder alloy described in Patent Literature 1 has a melting point of 137 to 139°C. Since the joining temperature at the time of mounting often needs to be about the melting point + 20°C, the joining temperature at the time of mounting needs to be 157°C or more, and joining is not possible at 135°C or less.

Likewise, since the Sn-Bi-In-based solder alloy described in Patent Literature 2 has a melting point of 117 to 139°C, the joining temperature at the time of mounting needs to be 137°C or more, and joining cannot be performed at 135°C or less. In addition, the solder alloy is made by mixing three kinds of metals: Sn-Bi-In, and heating and melting the mixture in an electric furnace (400°C). Therefore, it requires a step of "mixing of metal → heating and melting" as well as a step of "crushing → solder paste forming" as the next step to achieve a soldering material so that productivity is poor. The literature only describes that the solder alloy is plated on the surface of the object to be plated, without showing details of the plating treatment.

Since the Sn-In-Bi-based plating method described in Patent Literature 3 uses two types of two-component plating baths, it is necessary to replenish the two components to be consumed in the plating, complicating the operation management of the plating bath so that stabilizing the composition of the plated article is difficult. Furthermore, since the composition of the components in the plating bath is limited, it is expected that the range of composition of the plated laminate will be limited. Further, since the melting point is 180 to 220°C in the composition range of the solder alloy described in the Literature, the reflow temperature described is as high as about 260°C, so that joining cannot be performed when the joining temperature at the time of mounting is 135°C or less.

As mentioned above, in recent years, regulations on harmful substances such as RoHS regulations have become stricter, and Pb-containing solder alloys that have been used as conductive joining materials in the conventional production process of semiconductor products are also subject to regulation so that conversion to Pb-free solder alloys is required.

Further, with the progress of miniaturization of integrated circuits, there are demands for improvement of miniaturization accuracy of the joining method at the time of mounting, and cost reduction such as improvement of the process simplicity thereof.

In addition, in order to meet the demand for higher functionality of smartphones and sensors, there is expected increase in demand for wiring substrates and electronic elements with low heat resistance, such as resin substrates, piezoelectric elements, CdTe semiconductor elements, CCD elements, and hologram elements, which are used for flexible boards and stretchable boards. And along with which, there is a demand for the development of conductive joining materials and joining methods thereof that enable joining at low temperatures (135°C or less) in the mounting process.

The present invention has been made in view of such problems, and it is an object of the present invention to provide a low melting-point joining member which can be used for a low temperature joining method capable of joining at 135°C or less, a manufacturing method thereof, and the like.

### Solution to Problem

The melting points of Sn-Ag-base, Sn-Cu-base, and Sn-Ag-Cu-base, which are conventional Pb-free conductive joining materials, are 200°C or more, and the melting points of Sn-Bi-base and Sn-Bi-In-base are about 120°C or more. Since the reflow temperature (joining temperature) at the time of mounting needs to be higher than this by about 20°C, the reflow temperature is at least 140°C or more, which is not always suitable for a low temperature joining method.

However, as a result of diligent studies, the present inventors have found that it is possible to improve simplicity of the electronic component mounting process by obtaining a low melting-point plated laminate by performing laminated plating of Sn-Bi-In independently in a specific composition range on the surface of the object to be plated, and by using the plated laminate as it is, or solder alloy bumps which are made into bumps by heating and reflowing the plated laminate. The present inventors have also found that it is possible to perform mounting at a low temperature of 135°C or less. Based on these findings, the present invention has been completed.

That is, the gist of the present invention is as follows.

<1> A Sn-Bi-In-based low melting-point joining member, including a Sn-Bi-In alloy that has a composition within a range represented by a quadrangle in a Sn-Bi-In ternary phase diagram, the quadrangle having four vertices including: Point 1 (1, 69, 30), Point 2 (26, 52, 22), Point 3 (40, 10, 50), and Point 4 (1, 25, 74), where Point (x, y, z) is defined as a point of x mass% Sn, y mass% Bi and z mass% In, and that also has a melting point of 60 to 110°C.

<2> The Sn-Bi-In-based low melting-point joining member according to the above described <1>, wherein the Sn-Bi-In alloy has a composition within a range represented by a quadrangle in a Sn-Bi-In ternary phase diagram, the quadrangle having four vertices including: Point 1 (1, 69, 30), Point 2 (26, 52, 22), Point 3 (40, 10, 50), and Point 4a (1, 57, 42), where Point (x, y, z) is defined as a point of x mass% Sn, y mass% Bi and z mass% In.

<3> The Sn-Bi-In-based low melting-point joining member according to the above described <1> or <2>, wherein the Sn-Bi-In alloy has a composition within a range represented by a quadrangle in a Sn-Bi-In ternary phase diagram, the quadrangle having four vertices including: Point 1 (1, 69, 30), Point 2 (26, 52, 22), Point 3a (35, 25, 40), and Point 4b (1, 59, 40), where Point (x, y, z) is defined as a point of x mass% Sn, y mass% Bi and z mass% In, and also has a melting point of 69 to 110°C.

<4> The Sn-Bi-In-based low melting-point joining member according to any of the above described <1> to <3>, wherein the Sn-Bi-In alloy contains one or more mixed components selected from the group consisting of Ag, Cu, Ni, Zn, and Sb, and wherein a total mass of the mixed components in the Sn-Bi-In alloy is 0.001 to 3.0 mass%.

<5> The Sn-Bi-In-based low melting-point joining member according to any of the above described <1> to <4>, wherein the Sn-Bi-In alloy is disposed on a film formed of one or more kinds of undermetal selected, as the undermetal, from the group consisting of Ti, Ni, Cu, Au, Sn, Ag, Cr, Pd, Pt, W, Co, TiW, NiP, NiB, NiCo, and NiV.

<6> The Sn-Bi-In-based low melting-point joining member according to any of the above described <1> to <5>, wherein the Sn-Bi-In alloy has a composition containing Sn: 22 to 30 mass%, Bi: 20 to 28 mass%, and In: 42 to 58 mass%, or Sn: 15 to 19 mass%, Bi: 43 to 51 mass%, and In: 30 to 42 mass%, when a total amount of Sn, Bi, and In is 100 mass%.

<7> The Sn-Bi-In-based low melting-point joining member according to any of the above described <1> to <6>, wherein the Sn-Bi-In alloy has a plated laminate including a plurality of layers having different concentrations of Sn, Bi, and In.

<8> The Sn-Bi-In-based low melting-point joining member according to the above described <7>, wherein the plated laminate includes, at least, a SnIn layer containing Sn and In, and a BiIn layer containing Bi and In.

<9> The Sn-Bi-In-based low melting-point joining member according to any of the above described <1> to <6>, wherein the Sn-Bi-In alloy is a solder alloy bump which is formed by heating and reflowing a plated laminate having a plurality of layers having different concentrations of Sn, Bi, and In.

<10> The Sn-Bi-In-based low melting-point joining member according to any of the above described <1> to <9>, further including a micro member having the Sn-Bi-In alloy on a surface of any micro core material selected from the group consisting of a micro metal ball having a size of 1 mm or less, a micro resin ball having a coating layer of conductive metal, a micro resin ball having a coating layer of solder alloy, and a micro pin member.

<11> The Sn-Bi-In-based low melting-point joining member according to the above described <10>, wherein the micro member is mounted on a conductive joining portion.

<12> A method for producing a Sn-Bi-In-based low melting-point joining member, including a plating step of forming a plated laminate on an object to be plated, the plated laminate including a laminated plating layer obtained by performing Sn plating, Bi plating, and In plating respectively such that the laminated plating layer has a composition within a range represented by a quadrangle in a Sn-Bi-In ternary phase diagram, the quadrangle having four vertices including: Point 1 (1, 69, 30), Point 2 (26, 52, 22), Point 3 (40, 10, 50), and Point 4 (1, 25, 74), where Point (x, y, z) is defined as a point of x mass% Sn, y mass% Bi and z mass% In.

<13> The method for producing a Sn-Bi-In-based low melting-point joining member according to the above described <12>, wherein the object to be plated has a film formed of one or more undermetals selected from the group consisting of Ti, Ni, Cu, Au, Sn, Ag, Cr, Pd, Pt, W, Co, TiW, NiP, NiB, NiCo, and NiV, and the plated laminate is formed on the film.

<14> The method for producing a Sn-Bi-In-based low melting-point joining member according to the above described <12> or <13>, wherein plating to be first performed on the object to be plated is Sn plating or Bi plating, and the In plating is performed after the Sn plating and the Bi plating are performed.

<15> The method for producing a Sn-Bi-In-based low melting-point joining member according to any of the above described <12> to <14>, wherein the plated laminate contains one or more mixed components selected from the group consisting of Ag, Cu, Ni, Zn, and Sb, and a total mass of the mixed components in the plated laminate is 0.001 to 3.0 mass%.

<16> The method for producing a Sn-Bi-In-based low melting-point joining member according to any of the above described 12 to 15, wherein the laminated plating layer is formed such that the Sn-Bi-In alloy has a composition including Sn: 22 to 30 mass%, Bi: 20 to 28 mass%, and In: 42 to 58 mass%, or Sn: 15 to 19 mass%, Bi: 43 to 51 mass%, and In: 30 to 42 mass%, when a total amount of Sn, Bi, and In is 100 mass%.

<17> The method for producing a Sn-Bi-In-based low melting-point joining member according to any of the above described <12> to <16>, wherein the object to be plated is a micro core material, whose size is 1 mm or less, and which is selected from the group consisting of a micro metal ball, a micro resin ball having a coating layer of a conductive metal, a micro resin ball having a coating layer of a solder alloy, and a micro pin member, and in the plating step, a micro member in which the micro core material is coated with the plated laminate is produced.

<18> A method for producing a Sn-Bi-In-based low melting-point joining member, including forming a bump by heating and reflowing a Sn-Bi-In-based low melting-point joining member which is produced by the method for producing a Sn-Bi-In-based low melting-point joining member according to any of the above described <12> to <17>, and which is disposed on a conductive joining portion.

<19> A semiconductor electronic circuit, including a Sn-Bi-In-based low melting-point joining member according to any one of the above described <1> to <11>.

<20> A method for mounting a semiconductor electronic circuit, including heating and reflowing the Sn-Bi-In-based low melting-point joining member according to any of the above described <1> to <11>, which is disposed between a wiring substrate and a semiconductor chip surface, in a range of 80 to 135°C, thereby joining the wiring substrate and the semiconductor chip with the Sn-Bi-In-based low melting-point joining member.

### Advantageous Effects of Invention

The Sn-Bi-In-based low melting-point joining member of the present invention can be joined at a low temperature and is excellent in low temperature mountability. Further, the method for producing a Sn-Bi-In-based low melting-point joining member of the present invention provides a method for producing such a joining member, and allows a Pb-free composition to be easily adjusted.

### Brief Description of Drawings

[Figure 1] Figure 1 is a Sn-Bi-In ternary phase diagram according to the present invention.
[Figure 2] Figure 2 is a Sn-Bi-In ternary phase diagram according to the present invention.
[Figure 3] Figure 3 is a conceptual diagram of production process until a solder alloy bump is formed by using a plated laminate of the present invention.
[Figure 4] Figure 4 is a conceptual diagram of mounting process by an alloy bump using a plated laminate of the present invention.
[Figure 5] Figure 5 shows a DSC chart of Experimental example 2.
[Figure 6] Figure 6 shows a DSC chart of Experimental example 4.
[Figure 7] Figure 7 shows a DSC chart of Experimental example 5.
[Figure 8] Figure 8 shows a DSC chart of Experimental example 7.
[Figure 9] Figure 9 shows a DSC chart of Experimental example 8.
[Figure 10] Figure 10 shows a DSC chart of Experimental example 10.
[Figure 11] Figure 11 shows a DSC chart of Experimental example 12.
[Figure 12] Figure 12 shows a DSC chart of Experimental example 14.
[Figure 13] Figure 13 shows a DSC chart of Experimental example 15.
[Figure 14] Figure 14 shows a DSC chart of Experimental example 17.
[Figure 15] Figure 15 shows a DSC chart of Experimental example 18.
[Figure 16] Figure 16 shows a DSC chart of Experimental example 19.
[Figure 17] Figure 17 shows a DSC chart of Experimental example 22.
[Figure 18] Figure 18 shows a DSC chart of Experimental example 30.
[Figure 19] Figure 19 shows a DSC chart of Experimental example 32.
[Figure 20] Figure 20 shows a DSC chart of Experimental example 33.
[Figure 21] Figure 21 shows a DSC chart of Experimental example 37.
[Figure 22] Figure 22 shows a DSC chart of Experimental example 39.
[Figure 23] Figure 23 shows a DSC chart of Experimental example 41.
[Figure 24] Figure 24 is an appearance SEM image of a plated laminate of Experimental example 47.
[Figure 25] Figure 25 shows a SEM-EDX sectional image of a plated laminate of Experimental example 47.
[Figure 26] Figure 26 is an appearance SEM image of a bump of Experimental example 47.
[Figure 27] Figure 27 is an appearance SEM image of a bump of Experimental example 47.
[Figure 28] Figure 28 is a SEM-EDX sectional image of a bump of Experimental example 47.
[Figure 29] Figure 29 is an appearance SEM image of a plated laminate of Experimental example 48.
[Figure 30] Figure 30 is an appearance SEM image of a bump of Experimental example 48.
[Figure 31] Figure 31 is an appearance SEM image of a bump of Experimental example 48.
[Figure 32] Figure 32 is an appearance SEM image of a plated laminate of Experimental example 50.
[Figure 33] Figure 33 is an appearance SEM image of a bump of Experimental example 50.
[Figure 34] Figure 34 is an appearance SEM image of a bump of Experimental example 50.
[Figure 35] Figure 35 is a conceptual diagram of a shear strength tester.
[Figure 36] Figure 36 is a relation diagram between In concentration and bump shear strength.
[Figure 37] Figure 37 is an appearance image of a plated laminate onto a micro metal ball of Experimental example 58.
[Figure 38] Figure 38 is an appearance image of a plated laminate onto a micro resin ball of Experimental example 59.
[Figure 39] Figure 39 is an appearance image of a plated laminate onto a Cu pin of Experimental example 60.

### Description of Embodiments

The present invention will be described in detail below, but the present invention will not be limited to the following embodiments, and can be variously modified to be carried out within the scope of the gist thereof. Note that, when the expression "-" (or "to") is used in this specification, it shall be used as an expression including numerical values or physical property values before and after the expression.

### <Sn-Bi-In-based low melting-point joining member>

A Sn-Bi-In-based low melting-point joining member of the present invention includes a Sn-Bi-In alloy that has a composition within a range represented by a quadrangle in a Sn-Bi-In ternary phase diagram, the quadrangle having four vertices including: Point 1 (1, 69, 30), Point 2 (26, 52, 22), Point 3 (40, 10, 50), and Point 4 (1, 25, 74), where Point (x, y, z) is defined as a point of x mass% Sn, y mass% Bi and z mass% In, and that also has a melting point of 60 to 110°C. Hereinafter, "the Sn-Bi-In-based low melting-point joining member of the present invention" may be referred to simply as "the joining member of the present invention".

The joining member of the present invention can be joined at a low temperature, and is excellent in low temperature mountability.

### [Sn-Bi-In alloy]

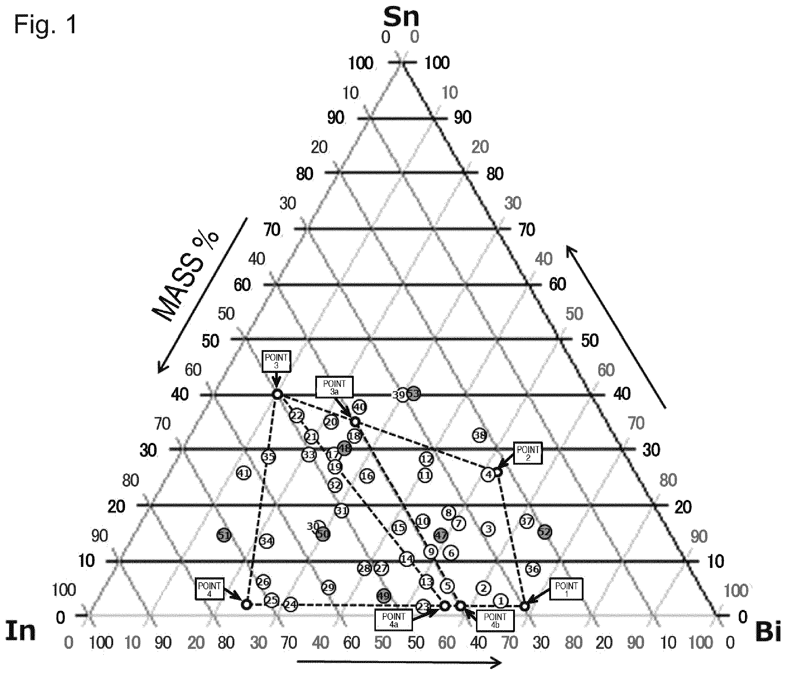

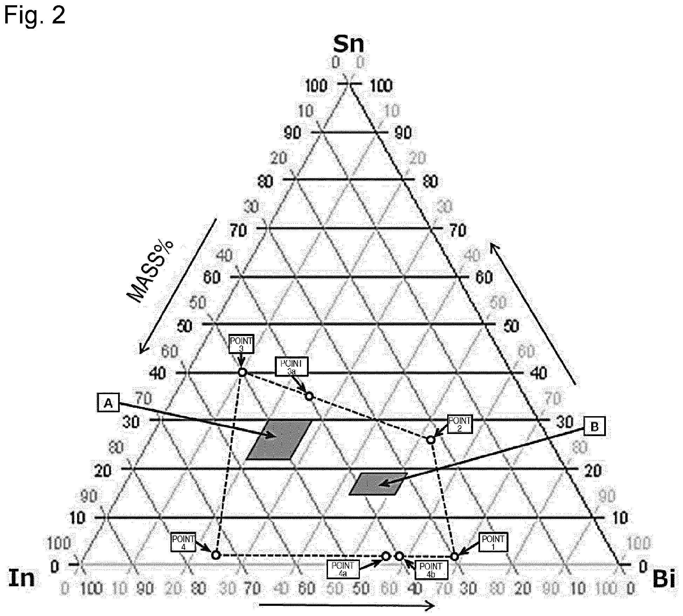

Figures 1 and 2 are diagrams for explaining a Sn-Bi-In ternary phase diagram relating to the joining member of the present invention and the production method of the present invention. In the Sn-Bi-In alloy used for the joining member according to the present invention, the concentrations of Sn (tin), Bi (bismuth), and In (indium) are controlled such that the alloy has a composition within a range represented by a quadrangle in a Sn-Bi-In ternary phase diagram, the quadrangle having four vertices including: Point 1 (1, 69, 30), Point 2 (26, 52, 22), Point 3 (40, 10, 50), and Point 4 (1, 25, 74), where Point (x, y, z) is defined as a point of x mass% Sn, y mass% Bi, and z mass% In.

Hereinafter, the quadrangle having four vertices including: Point 1, Point 2, Point 3, and Point 4 may be referred to as a first quadrangle.

Using a Sn-Bi-In alloy having a composition within the range of the first quadrangle (hereinafter, may be simply referred to as a "Sn-Bi-In alloy") as a joining member can significantly contribute to realization of low-temperature mounting of an integrated circuit. Arranging the composition within the range of the first quadrangle allows the melting point of the Sn-Bi-In alloy to be stably set to 60 to 110°C. This enables joining by heating and reflowing in a low temperature region of 135°C or less, which is suitable for low temperature mounting. Further, since treatment can be performed at a low temperature, it is possible to reduce the energy consumed at the time of mounting. Furthermore, when plating is used, it is also possible to reduce the energy consumed for the heat treatment at the time of production.

The range of the first quadrangle is defined by lines on four sides including: a line connecting Point 1 (1, 69, 30) and Point 4 (1, 25, 74), a line connecting Point 1 (1, 69, 30) and Point 2 (26, 52, 22), a line connecting Point 2 (26, 52, 22) and Point 3 (40, 10, 50), and a line connecting Point 3 (40, 10, 50) and Point 4 (1, 25, 74). Within this range, the Sn-Bi-In alloy has a highest melting point of 60 to 110°C.

Outside the line connecting Point 1 (1, 69, 30) and Point 4 (1, 25, 74) (the lower side in Figures 1 and 2), the alloy will not contain Sn so that wettability with an object to be plated or an object to be joined deteriorates, thus reducing the joining strength or joining durability. Moreover, when a minute amount of Sn is contained, it becomes easier to obtain a Sn-Bi-In alloy having a melting point of 110°C or less, and to prepare a Sn-Bi-In alloy having a melting point of 60 to 110°C.

Outside the line connecting Point 1 (1, 69, 30) and Point 2 (26, 52, 22) (the right side in Figures 1 and 2), as shown in Examples to be described below, the melting point becomes higher due to residual Bi. For example, in Experimental examples 36 and 37, an endothermic peak occurred at 271°C near the melting point of Bi.

Outside the line connecting Point 2 (26, 52, 22) and Point 3 (40, 10, 50) (the upper side in Figures 1 and 2), as shown in Examples to be described below, the melting point becomes higher due to residual Sn-Bi alloy and residual Bi. Moreover, the melting point becomes higher due to residual Sn. For example, in Experimental example 38, endothermic peaks occurred at 136°C near the melting point of Sn-58Bi, and 271°C near the melting point of Bi. Further, in Experimental example 39, an endothermic peak occurred at 232°C near the melting point of Sn, and in Experimental example 40, an endothermic peak occurred at 220°C near the melting point of Sn.

Outside the line connecting Point 3 (40, 10, 50) and Point 4 (1, 25, 74) (the left side in Figures 1 and 2), the melting point becomes higher as shown in Examples to be described below. For example, in Experimental example 41, an endothermic peak at 128°C, which seems to be due to a residue of an In-Sn-based complex having a high proportion of In, occurred. Moreover, due to a higher proportion of relatively expensive In, the cost increases and the versatility deteriorates.

The mass concentration in the above described ternary phase diagram indicates the concentration of each component of Sn, Bi, and In when conversion is made when a total of Sn, Bi, and In is assumed to be 100 mass% in a Sn-Bi-In alloy portion such as a plated laminate, a solder alloy bump, and a coating layer of a micro core material to be described later.

The Sn-Bi-In alloy preferably has a composition within a range represented by a quadrangle in the Sn-Bi-In ternary phase diagram, the quadrangle having four vertices including: Point 1 (1, 69, 30), Point 2 (26, 52, 22), Point 3 (40, 10, 50), and Point 4a (1, 57, 42), where Point (x, y, z) is defined as a point of x mass% Sn, y mass% Bi and z mass% In.

Hereinafter, the quadrangle having four vertices including: Points 1, Point 2, Point 3, and Point 4a may be referred to as a second quadrangle.

By using a joining member containing a Sn-Bi-In alloy having a composition within the range represented by the second quadrangle, it is possible to obtain a joining member having an adhesive strength higher than 3.3 mg/µm² which is the adhesive strength of a joining member containing an existing Pb-free solder alloy (Sn2.5Ag, Sn3.2Ag, Sn58Bi alloy, etc.) as will be described later in Examples. By using a joining member containing a Sn-Bi-In alloy having a composition within the range represented by the second quadrangle, the joining reliability is further improved.

The melting point of the Sn-Bi-In alloy used for the joining member of the present invention is 60°C to 110°C. The melting point of the Sn-Bi-In alloy is preferably 65°C to 110°C, and more preferably 69°C to 110°C. Electronic products that use solder alloys as the conductive joining material when mounting semiconductor electronic components are used in normal usage environments where seasonal fluctuations, indoor/outdoor fluctuations, and self-heating due to the operation of electronic products occur. Therefore, when the melting point is about 60°C to 62°C, there is a concern that joining strength of the alloy may decrease, and durability thereof may be insufficient.

In the present application, the "melting point" refers to a top temperature of an endothermic peak when measured by DSC, as described in Examples to be described later. When there are a plurality of endothermic peaks, the lowest temperature among the top temperatures of the endothermic peaks is treated as a lowest melting point (solidus temperature), and the highest temperature is treated as a highest melting point (liquidus temperature).

For the Sn-Bi-In alloy is observed, in the DSC measurement, to have melting points from a lowest melting point (solidus temperature) to a highest melting point (liquidus temperature) in a temperature range of 60°C to 110°C, preferably in a temperature range of 65°C to 110°C, and more preferably in a temperature range of 69°C to 110°C.

From the viewpoint of adhesive strength and melting point, the Sn-Bi-In alloy preferably has a composition within a range represented by a quadrangle in a Sn-Bi-In ternary phase diagram, the quadrangle having four vertices including: Point 1 (1, 69, 30), Point 2 (26, 52, 22), Point 3a (35, 25, 40), and Point 4b (1, 59, 40), where Point (x, y, z) is defined as a point of x mass% Sn, y mass% Bi and z mass% In, and also has a melting point of 69 to 110°C.

Hereinafter, the quadrangle having four vertices including: Point 1, Point 2, Points 3a, and Point 4b may be referred to as a third quadrangle.

The Sn-Bi-In alloy having a composition within the range represented by the third quadrangle can exhibit a melting point of 69 to 110°C stably, and can be joined by heating and reflowing in a low temperature region of 90 to 135°C, which is suitable for low temperature mounting. Moreover, is also excellent in joining reliability.

In the DSC measurement of Sn-Bi-In alloy, since those that show DSC charts as shown in (a) to (c) below have a narrow temperature range of the melting point which appears as a endothermic peak (from a solidus temperature to a liquidus temperature), it is possible to reduce the time for heating and reflowing at the time of mounting, and the effect of improving the joining reliability can be expected:
(a) a profile which shows a single endothermic peak,
(b) a profile which shows a plurality of endothermic peaks, but in which compared to the height of the largest endothermic peak, the height of any other endothermic peak is 1/10 or less, and
(c) a profile which shows a plurality of endothermic peaks each having a large endothermic peak, but in which the difference in the top temperature among the endothermic peaks each having a large endothermic peak is 5°C or less.

In the viewpoint of time reduction of heating and reflowing and joining reliability at the time of mounting, the Sn-Bi-In alloy may have a composition containing: when a total of Sn, Bi, and In is 100 mass%, Sn: 22 to 30 mass%, Bi: 20 to 28 mass%, and In: 42 to 58 mass% (composition in the range of A of Figure 2), or Sn: 15 to 19 mass%, Bi: 43 to 51 mass%, and In: 30 to 42 mass% (composition in the range of B of Figure 2) .

When the total of Sn, Bi, and In is 100 mass%, the Sn-Bi-In alloy containing Sn: 22 to 30 mass%, Bi: 20 to 28 mass%, and In: 42 to 58 mass% will exhibit a large endothermic peak height in a range of 60 to 65°C in the DSC measurement.

For example, as shown in Experimental example 32 and Experimental example 33, even when a plurality of endothermic peaks are observed, there is only one endothermic peak that has a large endothermic peak height. Further, compared to the endothermic peak having this large endothermic peak height, the peak height of any other endothermic peak is 1/10 or less. In the Sn-Bi-In alloy containing Sn: 23 mass%, Bi: 28 mass%, and In: 49 mass% as shown in Experimental example 32, although a shoulder peak having a small endothermic peak height is observed at 70°C, the endothermic peak observed at 61°C is only one endothermic peak that has a large endothermic peak height. Moreover, in the Sn-Bi-In alloy containing Sn: 29 mass%, Bi: 21 mass%, and In: 50 mass% as shown in Experimental example 33, although a shoulder peak is observed at 72°C on the tailing, the endothermic peak observed at 60°C is only one endothermic peak that has a large endothermic peak height.

Further, even when a plurality of endothermic peaks each having a large endothermic peak height are shown, the difference in the top temperature among the endothermic peaks is 5°C or less. In the Sn-Bi-In alloy containing Sn: 29 mass%, Bi: 25 mass%, and In: 46 mass% as shown in Experimental example 17, although endothermic peaks each having a large endothermic peak height are observed at 60°C and 61°C, the temperature difference between the tops of these peaks is 5°C or less. In the Sn-Bi-In alloy containing Sn: 27 mass%, Bi: 26 mass%, and In: 47 mass% as shown in Experimental example 19, although endothermic peaks each having a large endothermic peak height are observed at 60°C and 63°C, the temperature difference between the tops of these peaks is 5°C or less.

When the total of Sn, Bi, In is 100 mass%, the Sn-Bi-In alloy containing Sn: 15 to 19 mass%, Bi: 43 to 51 mass%, and In: 30 to 42 mass% will exhibit a large endothermic peak height in a range of 80 to 85°C in the DSC measurement.

For example, as shown in Experimental example 7 and Experimental example 8, even when a plurality of endothermic peaks are observed, compared to the endothermic peak having the large endothermic peak height, the peak height of any other endothermic peak is 1/10 or less. In the Sn-Bi-In alloy containing Sn: 17 mass%, Bi: 51 mass%, and In: 32 mass% as shown in Experimental example 7, although a endothermic peak having a small endothermic peak height is observed at 70°C, the endothermic peak observed at 83°C is only one endothermic peak that has a large endothermic peak height. In the Sn-Bi-In alloy containing Sn: 19 mass%, Bi: 48 mass%, and In: 33 mass% as shown in Experimental example 8, although a endothermic peak having a small endothermic peak height is observed at 70°C and 108°C, the endothermic peak observed at 82°C is only one endothermic peak that has a large endothermic peak height. Moreover, in the Sn-Bi-In alloy containing Sn: 17 mass%, Bi: 45 mass%, and In: 38 mass% as shown in Experimental example 10, a single endothermic peak is observed at 83°C.

### (Mixed components)

The Sn-Bi-In alloy may contain a mixed component appropriately added for the purpose of improving physical properties such as smoothness and adhesiveness of the film of the laminated plating layer within a range where the melting point is not more than 110°C.

For example, the Sn-Bi-In alloy may contain one or more mixed components selected from the group consisting of Ag, Cu, Ni, Zn, and Sb, in which the percentage of the total mass of mixed components in the Sn-Bi-In alloy (total mass of mixed components/mass of Sn-Bi-In alloy) is within a range of 0.001 to 3.0 mass%. The percentage of the total mass of mixed components in the Sn-Bi-In alloy may be 0.005 mass% or more, 0.01 mass% or more, 0.05 mass% or more, or 0.1 mass% more. Moreover, the percentage of the total mass of mixed components in the Sn-Bi-In alloy may be 2.5 mass% or less, 2.0 mass% or less, 1.5 mass% or less, or 1.0 mass% or less.

In addition, it is preferable to reduce the mixed amount of Pb for using as Pb-free, and the concentration of Pb in the Sn-Bi-In alloy is preferably 0.1 mass% or less, more preferably 0.05 mass% or less, and more preferably 0.01 mass% or less. Further preferably, the concentration of Pb is not more than the lower limit of detection.

Further, the Sn-Bi-In alloy may contain impurities that are inevitably contained in the raw material and the production process. Examples of such impurities include Fe (iron) and C (carbon).

Further, the percentage of the total amount of Sn, Bi and In with respect to the Sn-Bi-In alloy (total mass of Sn, Bi and In/whole mass of Sn-Bi-In alloy) is preferably 70 mass% or more, more preferably 80 mass% or more, further preferably 90 mass% or more, and further preferably 95 mass% or more. Moreover, it may be 97 mass% or more, 98 mass% or more, and 99 mass% or more.

### (Plated laminates)

The Sn-Bi-In alloy can form a plated laminate having a plurality of layers having different concentrations of Sn, Bi, and In. That is, the joining member of the present invention may have a composition within a range of the first quadrangle, and include a laminated plating layer in which a plurality of layers having different concentrations of Sn, Bi, and In are laminated. As described in the production method of the present invention, it is possible to obtain a joining member of the present invention by forming a plated laminate on the surface of a substrate or a micro core material.

The Sn-Bi-In alloy can form a plated laminate having a SnIn layer in which In is diffused in the layer by Sn plating and/or a BiIn layer in which In is diffused in the layer by Bi plating. For example, it is possible to form a plated laminate having at least a SnIn layer containing Sn and In, and a BiIn layer containing Bi and In. By having an alloy layer of SnIn layer and/or BiIn layer, it is possible to obtain a low melting point of 60 to 110°C, which is significantly lower than the melting point of each of Sn, Bi, and In alone. The plated laminate will be described in detail in the production method of the present invention.

### (Solder alloy bump)

The Sn-Bi-In alloy can form a solder alloy bump. For example, by heating and reflowing a plated laminate having a plurality of layers having different concentrations of Sn, Bi, and In, it is possible to form a solder alloy bump. By heating and reflowing a plated laminate formed on a substrate, it is possible to obtain a joining member including a solder alloy bump made up of a substrate and a Sn-Bi-In alloy formed on the substrate.

### (Coating layer of micro core material)

The Sn-Bi-In alloy can form a coating layer for coating the surface of any micro core material whose size is 1 mm or less and which is selected from the group consisting of a micro metal ball, a micro resin ball having a coating layer of conductive metal, a micro resin ball having a coating layer of solder alloy, and a micro pin member. Coating of a micro core material may be performed by coating with plating or coating with a Sn-Bi-In alloy.

### [Joining member]

Since the Sn-Bi-In alloy has a melting point in a range of 60 to 110°C, it melts when heated at or above the melting point, and is solid below the melting point and around normal temperature of about 20 to 30°C. Since a plated laminate and a solder alloy bump, which are made of a Sn-Bi-In alloy, function as a joining portion, a member which has a plated laminate or a solder alloy bump as a joining portion, and is to be joined to an object to be joined is called as a joining member in the present application.

Moreover, the joining member of the present invention may be provided with a micro core material coated with a Sn-Bi-In alloy as a joining portion, and may be joined to an object to be joined.

The joining member of the present invention may be a plated laminate itself made of a Sn-Bi-In alloy, or a solder alloy bump itself made of a Sn-Bi-In alloy.

The joining member of the present invention may have a substrate and a Sn-Bi-In alloy formed on the substrate (a plated laminate or a solder alloy bump). For example, the joining member of the present invention may be made up of a substrate having an undermetal layer including one or more undermetals selected from the group consisting of Ti, Ni, Cu, Au, Sn, Ag, Cr, Pd, Pt, W, Co, TiW, NiP, NiB, NiCo, and NiV, and a Sn-Bi-In alloy disposed on the undermetal layer. Examples of the substrate having an undermetal layer include semiconductor chips, or the like.

The joining member of the present invention may have a micro member having a Sn-Bi-In alloy (a plated laminate or a coating layer made of a solder alloy) on the surface of a micro core material. Moreover, a micro member having a Sn-Bi-In alloy on the surface of the micro core material, may be disposed on a substrate or the like to obtain a joining member. For example, by mounting a micro member, in which a micro core material is coated with a plated laminate, on a conductive joining portion of the substrate provided with the conductive joining portion, and subjecting them to heating and reflowing, it is possible to obtain a joining member having a substrate provided with the conductive joining portion, and a micro member mounted on the conductive joining portion (micro member mounting-type bump).

As a member for forming a plated laminate or a solder alloy bump, and a member for arranging a micro core material and a micro member, in which the surface of the micro core material is coated with a Sn-Bi-In alloy, the object to be plated described in the production method of the present invention can be used.

### <Production method of Sn-Bi-In-based low melting-point joining member>

A joining member of the present invention can be obtained, for example, by a method of mixing respective raw material metals of a Sn-Bi-In alloy and melting them to make a Sn-Bi-In-based low melting point solder alloy; a method of performing laminated plating of each of the three components (plating lamination method) on the surface of an object to be plated such that the Sn-Bi-In concentrations are within a predetermined composition to form a low melting-point plated laminate; and a method of heating and reflowing this plated laminate to form a Sn-Bi-In-based low melting point solder alloy bump.

Among these, the method utilizing a low melting-point plated laminate is easier in adjusting the composition, and allows to perform alloying of the Sn-Bi-In and bump formation thereof at once so that such method is excellent in convenience and joining reliability, and is industrially usable.

<Production method of present invention>

A Sn-Bi-In-based low melting-point joining member of the present invention is preferably produced by the method for producing a Sn-Bi-In-based low melting-point joining member (hereinafter this production method may be referred to as a production method of the present invention) including a plating step of forming a plated laminate including laminated plating layers, which are obtained by respectively performing Sn plating, Bi plating, and In plating on the object to be plated such that the composition is within a range of the first quadrangle.

The production method of the present invention can easily adjust the composition of Pb-free. Moreover, by laminating each element by plating, reproducibility of the composition of the plated laminate can be achieved, and it is easy to arbitrarily control the composition so that the composition is within a composition range of the Sn-Bi-In system according to the present invention.

In the present application, it is possible to mutually utilize the joining member of the present invention and the configuration corresponding to each aspect of the production method of the present invention.

Hereinafter, materials and each step to be used in the production method of the present invention will be described.

### [Object to be plated]

The object to be plated is a member on which a plated laminate is formed. Further, since a solder alloy can be formed by heating and reflowing a plated laminate formed on the substrate, the object to be plated may also be a member on which solder bumps are formed.

### (Substrate)

Examples of the object to be plated include semiconductor electronic components such as LSIs and semiconductor chips, and substrates of wiring substrates such as printed wiring boards for obtaining packages or modules in which a plurality of semiconductor electronic components are mounted to make up circuits. As these members, those in which the required conductive joining portion (pad) is patterned on the surface thereof, if necessary, by photolithography or the like can be used.

### (Formation of undermetal)

Moreover, as the object to be plated, it is also possible to use a substrate formed with a pattern of a conductive joining portion, on the surface of which a film of one or more undermetals selected from the group consisting of Ti (titanium), Ni (nickel), Cu (copper), Au (gold), Sn (tin), Ag (silver), Cr ( Chrome), Pd (palladium), Pt (platinum), W (tungsten), Co (cobalt), TiW (titanium-tungsten), NiP (nickel-phosphorus), NiB (nickel-boron), NiCo (nickel-cobalt), And NiV (nickel-vanadium), if necessary, is formed (for example, a substrate having an undermetal layer). These undermetals may be used alone or two or more in combination. As the film forming method of undermetal, an applicable method may be appropriately selected from vapor deposition, PVD, plating method and the like. The thickness of the film to be formed may be appropriately set in a range of 0.01 to 10 µm for each.

### (Formation of conductive post)

Moreover, it is also possible to use, as the object to be plated, a layer of undermetal, on which columnar conductive posts which are provided for the purpose of preventing short circuiting during mounting (during heating and reflowing) by arranging the solder alloys of the conductive joining material at narrow intervals (narrow pitch) along with the miniaturization of integrated circuits, are formed. The columnar post material may be appropriately selected from conductive metals such as Cu, Ag, and Ni. Formation of the columnar post may be performed by appropriately selecting and using an applicable method from PVD, plating, and the like. The height of the columnar post is usually in a range of 1 to 200 µm, and may be appropriately set as needed.

### (Micro core material)

As described below, it is also possible to use, as the object to be plated, any micro core material, whose size is 1 mm or less, and which is selected from the group consisting of a micro metal ball, a micro resin ball having a coating layer of conductive metal, a micro resin ball having a coating layer of solder alloy, and a micro pin member. By using these as the object to be plated, it is possible to obtain a joining member of micro member.

A micro ball which is used as a core ball of conductive joining material of a micro ball mounting type such as a ball grid array (BGA) can be used as the object to be plated. As the micro ball, which has a diameter of 1 mm or less, a micro metal ball or a micro resin ball can be used. In particular, micro resin balls are used as a core-ball material which is effective for weight reduction and thermal stress relaxation (elastic deformability) of electronic circuit parts.

As the micro metal ball, for example, any conductive metal sphere such as of Cu, Ni-Co-Fe alloy, or Ni-Fe alloy, which has a diameter of 0.05 to 1.0 mm, can be used. Further, as needed, it is also possible to use a micro metal ball which is provided with a conductive coating such as Ni, Cu, or solder, which has a thickness of 0.1 to 30 µm, on the surface thereof.

As the micro resin ball, it is possible to use, for example, any of general resins such as acrylic resin, polypropylene resin, vinyl chloride resin, polyphenylene sulfide, and divinylbenzene crosslinked polymer, which can be used to form a micro ball having a diameter of 0.05 to 1.0 mm. Since these micro resin balls are non-conductive, those whose surface is coated with a conductive metal or alloy such as Ni, Cu, or solder of about 0.5 to 5.0 µm by electroless plating or the like are used.

Further, the core material is not limited to a ball shape, and micro pins such as a columnar shape, a prismatic shape, a weight shape, and those shapes with corners thereof being chamfered can be used. As the micro pin, a micro metal pin or a micro resin pin having the same material and size as the above-mentioned micro metal ball or micro resin ball can be used. In the case of the micro pin, it is assumed that the smallest side corresponds to the diameter of the micro metal ball or the micro resin ball.

### [Surface washing/drying of object to be plated]

The purpose of surface washing of the object to be plated is to remove and clean the deposits on the surface of the object to be plated, and a solvent capable of removing the deposits is selected and used. For example, examples of the organic solvent include lower alcohols such as methanol, ethanol, and isopropyl alcohol, and ketones such as acetone, methyl ethyl ketone (MEK), and isobutyl ketone (MIBK). Examples of the aqueous solvent include a combined use of ammonia, an organic amine compound, etc. and a hydrogen peroxide solution, and an aqueous solution to which an anionic, cationic, or nonionic surfactant is added. Of these solvents, appropriate ones are selected and used in consideration of not attacking the material of the object to be plated.

The surface washing of the object to be plated is performed by a method such as immersion in these solvents or shower washing with the solvents within a range of room temperature to 100°C. After washing with the solvent, the solvent component adhering to the surface may be washed with water to clean the surface.

Next, regarding the drying of the object to be plated, heat drying or ventilation drying may be performed in a range of room temperature to 100°C. It is also possible to omit the drying step and proceed to the following plating step.

### [Plating step]

The plating step is a step of forming, on the object to be plated, a plated laminate including laminated plating layers which is obtained by performing Sn plating, Bi plating, and In plating, respectively, such that the composition is within a range of the first quadrangle.

In performing the production method of the present invention, the plating method for forming each layer may be either electrolytic plating or electroless plating, but electrolytic plating is preferable in consideration of the required plating time and productivity.

Taking an example of electrolytic plating to describe a usable plating apparatus, it is possible to use a plating apparatus that can set an object to be plated on the negative electrode by using a soluble anode or an insoluble anode as the positive electrode by using a plating tank, which is made of a material having corrosion resistance to each plating solution to be used, and which is provided with a stirring function such as blade stirring, shaking, and squeegee stirring, and a rectifier capable of controlling the current value within a predetermined range.

In the plating step, at least Sn plating, Bi plating, and In plating are performed. Further, the Sn plating, the Bi plating, and the In plating are performed by appropriately adjusting the concentration of each plating solution, the immersion time in plating solution, and the like such that the composition of Sn, Bi, and In in the formed plated laminate is within the range of the first quadrangle.

In the plating step, it is preferable to perform Sn plating, Bi plating, and In plating such that the composition of Sn, Bi and In in the plated laminate is within the range of the second quadrangle. Further, it is more preferable to perform Sn plating, Bi plating, and In plating such that a plated laminate having a composition within the range of the third quadrangle and having a melting point of 69 to 110°C is formed.

Further, the Sn plating, Bi plating, and In plating may be performed so as to obtain a composition containing Sn: 22 to 30 mass%, Bi: of 20 to 28 mass%, and In: 42 to 58 mass%, when the total of Sn, Bi, and In in the formed plated laminate is 100 mass%. Further, the Sn plating, Bi plating, and In plating may be performed so as to obtain a composition containing Sn: 15 to 19 mass%, Bi: 43 to 51 mass%, In: 30 to 42 mass%.

The method of plating each of Sn, Bi, and In will be illustrated below.

### (Sn plating)

Sn plating is a plating process performed by using a plating solution or the like containing Sn as a main component for plating an object to be plated. As the Sn plating solution, a commercially available one may be used, and examples thereof include a Sn plating solution manufactured by Ishihara Chemical Co., Ltd. The plating conditions may be arbitrary set, for example, under stirring using blade stirring, shaking, squeegee stirring, etc., within the ranges of temperature of 5 to 50°C, Sn ion concentration of 1 to 70 g/L in the plating solution, and current density of 0.1 to 20.0 A/dm². The Sn plating amount can be controlled by the plating processing time (immersion time in plating solution) under the set conditions.

### (Bi plating)

Bi plating is a plating process performed by using a plating solution or the like containing Bi as a main component for plating an object to be plated. As the Bi plating solution, a commercially available one may be used, and examples thereof include a Bi plating solution manufactured by Ishihara Chemical Co., Ltd. The plating conditions may be arbitrary set, for example, under stirring using blade stirring, shaking, squeegee stirring, etc., within the ranges of temperature of 5 to 50°C, Bi ion concentration of 1 to 70 g/L in the plating solution, and current density of 0.1 to 20.0 A/dm². The Bi plating amount can be controlled by the plating processing time (immersion time in plating solution) under the set conditions.

### (In plating)

In plating is a plating process performed by using a plating solution or the like containing In as a main component for plating an object to be plated. As the In plating solution, a commercially available one may be used, and examples thereof include In plating solutions manufactured by Ishihara Chemical Co., Ltd. and EEJA (Electroplating Engineers of Japan) Ltd. The plating conditions may be arbitrary set, for example, under stirring using blade stirring, shaking, squeegee stirring, etc., within the ranges of temperature of 5 to 50°C, In ion concentration of 1 to 70 g/L in the plating solution, and current density of 0.1 to 20.0 A/dm². The In plating amount can be controlled by the plating processing time (immersion time in plating solution) under the set conditions.

For these Sn plating, Bi plating, and In plating, a composite plating solution containing other plating components, such as optionally used mixed components, may be used. In a plating composition such as a plating solution, the total amount of other plating components with respect to the main component ("total amount of other plating components (g/L)"/"main component (g/L)") is preferably 50 mass% or less, more preferably 30 mass% or less, and more preferably 20 mass% or less. For example, a Sn/Cu composite plating solution in which Cu, which is an arbitrary mixed component, is mixed with a Sn plating solution, or a Sn/Ag composite plating solution in which Ag is mixed may be used as a Sn plating solution because it contains Sn as a main component. The same applies to the Bi plating solution and the In plating solution.

### (Addition of trace metal)

One or more mixed components selected from the group consisting of Ag, Cu, Ni, Zn, and Sb may be added within a range where the melting point of the plated laminate obtained as needed does not exceed 110°C for the purpose of improving the physical properties such as smoothness and adhesiveness of the film of the laminated plating layer. The mixed components can be added such that the percentage of the total mass of the mixed components in the total mass of the plated laminate (total mass of the mixed components/total mass of the plated laminate) is 0.001 to 3.0 mass%. These specific components can be mixed by performing alloying with a predetermined amount of metal to be mixed being contained when adjusting the alloy components. For example, they can be added to any of Sn, Bi, and In plating solutions and introduced into the coating film such that the content of the mixed component in the target Sn-Bi-In-based low melting-point plated laminate becomes a predetermined amount. It is also possible to use a plating solution containing a mixed component itself as the main component to perform single plating and introduce it into the plated laminate.

From the viewpoint of adjusting the precipitation potential with a complexing agent or the like to obtain alloyed plating with the mixed component (added metal), the added metal is preferably added in the Sn plating solution or the Bi plating solution. The amounts of these added metals to be added to the Sn or Bi plating solution may be appropriately selected and used in a range of 1/1000 to 1/10 with respect to the weight concentration of Sn or Bi such that a predetermined concentration is obtained in the obtained plated laminate.

### (Plating lamination order)

If Sn plating, Bi plating, and In plating are all performed, the order of plating lamination may be arbitrary. Specifically, in order from the surface of the object to be plated, any of the orders of Sn→Bi→In, Sn→In→Bi, Bi→Sn→In, Bi→In→Sn, In→Sn→Bi, In→Bi→Sn may be possible.

In order to stably laminate Sn-Bi-In with a predetermined composition by electrolytic plating, it is preferable to perform plating starting from the one having a high standard electrode potential and a low ionization tendency. Therefore, the first plating to be performed on the object to be plated is Sn plating or Bi plating, and it is preferable to perform In plating after performing Sn plating and Bi plating. That is, it is preferable to perform plating in the order of "Bi→Sn→In" or "Sn→Bi→In". With reference to the standard hydrogen electrode at 25°C and 10⁵ pascal (Pa), the standard electrode potentials are Bi = 0.317V, Sn = -0.138V, and In = -0.338V. If the In plating with the lowest potential among the three components is the first plating or the second plating, In is ionized and eluted in the electrolytic plating bath during the plating operation of the next component, and the concentration in the plated laminate of the final target product tends to be lower than the set condition. Therefore, it is preferable that the In plating is the final plating performed after the Sn plating and the Bi plating.

### (Plated laminate)

A plated laminate is formed by sequentially plating each component of Sn, Bi, and In independently. When the mixed component is not contained or when the mixed component is added to any of the Sn plating solution, the Bi plating solution, and the In plating solution, the plated laminate is a laminated plating layer obtained by performing Sn plating, Bi plating and In plating, respectively. Further, when single plating is performed using a plating solution containing a mixed component itself as the main component to introduce the mixed component, the plated laminate is made up of: a laminated plating layer obtained by performing Sn plating, Bi plating and In plating, respectively; and a plating layer obtained by plating a mixed component alone.

As described above, the plated laminate to be formed has a plurality of layers having different concentrations of Sn, Bi, and In. For example, the plated laminate to be formed has a SnIn layer in which In is diffused into a layer by Sn plating, and BiIn layer in which In is diffused into a layer by Bi plating.

The concentration of each element in the plated laminate can be determined by peeling the plated laminate from the object to be plated, dissolving it with the acid, and then quantitatively analyzing it with a high-frequency inductively coupled plasma-emission spectrometer. Each layer contains Sn, Bi, and In, each of which is the main metal of the layer, the SnIn layer contains Sn and In, and the BiIn layer contains Bi and In.

Each layer is preferably composed of metal elements substantially constituting the layer, but it may contain impurities inevitably contained in the raw materials or the production process in addition to the metal elements of the layer. Examples of such impurities include Fe (iron) and C (carbon).

Further, as described above, any additive element may be contained as a mixed component, but it is preferable to reduce the mixed amount of Pb for using as Pb-free. The concentration of Pb in the plated laminate is preferably 0.1 mass% or less, more preferably 0.05 mass% or less, and more preferably 0.01 mass% or less. It is more preferable that Pb is not more than a lower limit of detection.

### (Layer of Sn)

A layer of Sn obtained by Sn plating is a layer containing Sn. The layer of Sn contains Sn as the main component excluding In, and the Sn concentration in the elements excluding In in this layer is preferably 70 mass% or more, more preferably 80 mass% or more, and 90 mass% or more. This layer of Sn can be obtained by Sn plating.

Further, the layer of Sn may be a SnIn layer including In. This SnIn layer contains Sn and In as the main components of the layer, and the total of Sn and In may be 70 mass% or more, 80 mass% or more, 90 mass% or more, and 95 mass% or more in the layer. The SnIn layer contains both of them, and the mass ratio of Sn:In is 1:99 to 99:1, and may also be 5:95 to 95:5, 10:90 to 90:10, 20:80 to 80:20, and so on.

### (Layer of Bi)

A layer of Bi obtained by Bi plating is a layer containing Bi. The layer of Bi contains Bi as the main component excluding In, and the Bi concentration in the elements excluding In in this layer is preferably 70 mass% or more, more preferably 80 mass% or more, and 90 mass% or more. This layer of Bi can be obtained by Bi plating.

Further, the layer of Bi may be a BiIn layer including In. This BiIn layer contains Bi and In as the main components of the layer, and the total of Bi and In may be 70 mass% or more, 80 mass% or more, 90 mass% or more, and 95 mass% or more in the layer. The BiIn layer contains both of them, and the mass ratio of Bi:In is 1:99 to 99:1, and may also be 5:95 to 95:5, 10:90 to 90:10, 20:80 to 80:20, and so on.

### (Layer of In)

Since In contained in the laminated plating layer by In plating easily diffuses into the layer of Sn and the layer of Bi during the plating process, it is difficult to form a single layer containing In alone as the main component, and may be formed in the form of SnIn alloy or BiIn alloy.

### (Number of plated lamination)

The number of plated lamination is not particularly limited, and it is sufficient that there are at least two layers having different concentrations of Sn, Bi, and In. For the purpose of preventing alloying and diffusion of both components due to the interaction between the object to be plated and the plating components, it is possible to form layers having different concentrations of the above described three components, thereby laminating three layers, four layers, five layers, or the like.

### (Water washing/drying after each plating step)

The purpose of washing with water after each plating step is to remove the plating solution adhering to the surface of the object to be plated when it is pulled up from the plating bath, and it is cleaned by immersing it in water or washing it with water by a water shower. Subsequent drying may be performed at a temperature lower than the melting point of the plated laminate. Considering the melting point of the plated laminate, if the purpose is to remove moisture, the temperature may be usually set in a range of room temperature to 100°C appropriately, to perform heat drying or ventilation drying.

If there is no problem even if there is residual moisture in the next process, it is possible to skip the drying step and proceed to the next step.

The plated laminate formed on the object to be plated may be used as a joining member as in the state of the plated laminate. Moreover, a bump may be formed by using the plated laminate. Further, the plated laminate may be separated from the object to be plated as appropriate and used as a joining member.

### [Bumping step]

As described above, the joining member of the present invention may have a solder alloy bump or a micro member mounting-type bump, and the production method of the present invention may have a bumping step after the plating step. The bumping step is a step of heating and reflowing the plated laminate disposed on the conductive joining portion to form a solder alloy bump, or a step of heating and reflowing a micro member (micro core material coated with a plated laminate) disposed on the conductive joining portion to form a micro member mounting-type bump. The heating and reflowing are performed in a reducing atmosphere. Since the plated laminate having a composition within the range of the first quadrangle has a low melting point, it may be subjected to heating and reflowing in a low temperature region of 80 to 135°C to form a bump. From the viewpoint of joining strength and durability, a plated laminate having a composition within the range of the third quadrangle, and having a melting point of 69 to 110°C may be subjected to heating and reflowing in a low temperature region of 90 to 135°C, to form a bump.

Generally, in the formation of a bump, such as a solder alloy bump, by heating and reflowing, the alloy is required to have physical properties such as a uniform composition and a uniform spherical or hemispherical shape without surface unevenness. Further, as the physical properties at the time of mounting, the joining strength with the object to be plated of 3 mg/µm² or more, heat cycle durability, and the like are required. Preferably, the joining strength with the object to be plated is 3.3 mg/µm² or more. Factors that adversely affect these required physical properties include basic physical properties of the solder alloy itself, natural oxide films of the alloy component before heating and reflowing, and adhesion and mixing of impurities.

It is preferable to use a "formic acid gas reduction method" for the purpose of removing the natural oxide film at a low temperature at the time of heating and reflowing. As a method for removing a natural oxide film, generally, two types of methods shown below are available: the "formic acid gas reduction method" and the "hydrogen gas reduction method". Since the latter causes reduction reaction at 230°C or more, and the former causes reduction reaction at around 150°C, it is preferable to apply the "formic acid gas reduction method" which can be adapted to a low temperature region and is advantageous in terms of safety, reliability, and cost. That is, it is preferable that the bumping step is performed in a formic acid gas atmosphere.

Formic acid gas reduction method: MeO + HCOOH → Me + CO₂ + H₂O

Hydrogen gas reduction method: MeO + H₂ → Me + H₂O

The conditions for heating and reflowing can be appropriately selected according to the melting point of the plated laminate. For example, using the "formic acid gas reduction method", the conditions may be appropriately selected according to the composition of the plated laminate within the ranges of, reducing agent: formic acid, pressure: 20 to 400 mbar, heating rate: 10 to 150°C/min, top temperature: 70 to 110°C, and top temperature holding time: 20 to 300 seconds. Further, when the temperature range from the solidus temperature to the liquidus temperature of the plated laminate is a high temperature range such as 69 to 110°C or 80 to 85°C, heating and reflowing may be performed at a higher temperature in the ranges of, reducing agent: formic acid, pressure: 20 to 400 mbar, heating rate: 10 to 150°C/min, top temperature: 80 to 135°C, and top temperature holding time: 20 to 300 seconds. Bumps such as solder alloy bumps thus obtained are suitable for low temperature mounting because they can be joined in a low temperature region where the heating and reflowing temperature at the time of mounting is 80 to 135°C.

Depending on the object to be plated, another step may be included between the plating step and the bumping step. When the object to be plated is a substrate having a resist film, a step of removing the resist film may be included between the plating step and the bumping step. When the object to be plated is a micro core material, since a micro member in which the micro core material is coated with a plated laminate is obtained by performing a plating step, the bumping step may be performed after performing a step of disposing the micro member on a substrate.

Next, more specific examples of the production method of the present invention will be described.

### [Formation of plated laminate and solder alloy bump on conductive joining portion]

A method for producing a joining member, in which a plated laminate or a solder alloy bump made of a Sn-Bi-In alloy having a composition within the range of the first quadrangle is formed on the conductive joining portion of a substrate formed with a pattern of the conductive joining portion, will be described.

When forming a plated laminate on a conductive joining portion, the production method of the present invention includes a plating step and a resist film removing step. Further, when forming a solder alloy bump on the conductive joining portion, the production method of the present invention includes a plating step, a resist film removing step, and a bumping step.

### (Plating step)

In the plating step, a plated laminate is formed on a conductive joining portion. As the object to be plated, a substrate having a patterned conductive joining portion, and a resist film provided with opening through which the conductive joining portion is exposed (hereinafter, may be referred to as a "resist" or a "resist pattern") is used. The method of the plating step is as described above.

### (Resist film removing step)

By performing the resist film removing step after the plating step, a joining member, in which a plated laminate having a composition within the range of the first quadrangle is formed as a joining portion, is obtained on the conductive joining portion.

The resist film removing step is a step performed after the plating step, and is a step of removing the resist film provided on the substrate.

The removal of the resist pattern can be performed by using a known wet method such as immersion or shower washing in a chemical solution capable of removing resist without attacking the Sn-Bi-In-based low melting-point plated laminate, or a known dry method such as ashing treatment with oxygen plasma.

The chemical solution used in the wet method, examples of which include an organic solvent whose main component is dimethyl sulfoxide, etc., an aqueous solvent such as potassium hydroxide, and the like, may be appropriately selected considering the removability of the resist material and the durability of the plated precipitate.

After the resist is removed with the chemical solution, the object to be plated is washed by immersing in water or by water shower to clean it, and then subjected to heat drying or ventilation drying in a range of the room temperature to 100°C.

### (Bumping step)

After the resist film removing step, by heating and reflowing the plated laminate formed on the conductive joining portion, a solder alloy bump having a composition within the range of the first quadrangle is formed as a joining portion on the conductive joining portion. The bumping process is as described above.

A case where the plating process is performed in the order of Sn plating, Bi plating, and In plating in the plating step will be described as an example. By performing each step in the order of "surface washing/drying of the object to be plated → Sn plating → water washing/drying → Bi plating → water washing/drying → In plating → water washing/drying → resist removal → water washing/drying → solder alloy bumping (heating and reflowing)", a joining member formed with a solder alloy bump made of a Sn-Bi-In alloy having a composition within the range of the first quadrangle is obtained on the conductive joining portion of a substrate formed with a pattern of the conductive joining portion.

So far, the method for producing a joining member in which a plated laminate or a solder alloy bump is formed on a conductive joining portion, by using the production method of the present invention has been described.

Also, in a similar manner, by using a substrate in which an undermetal layer and/or a conductive post is formed on the conductive joining portion, it is possible to form a plated laminate or a solder alloy bump on the undermetal layer or the conductive post.

By utilizing such a production method, for example, a semiconductor chip or a wiring substrate formed with a pattern of a Sn-Bi-In-based laminated plating layer or a Sn-Bi-In-based solder alloy bump can be produced.

Conventionally, as a method for producing a solder alloy used as a conductive joining material, the following method is named in which: each alloy component is pulverized or crushed, surface-washed and dried, and combined and mixed to obtain a predetermined composition; the mixture is heated and melted at a temperature higher than the melting point of the mixed component having the highest melting point to obtain an alloy; the alloy is taken out in a lump form and is further crushed into alloy fine particles; the alloy fine particles are compounded with flux components, etc. to obtain solder alloy paste, etc.; and this paste is applied to the object to be plated to mount it by heating and reflowing. The joining member of the present invention may also be produced by this production method. On the other hand, this method has many steps and the productivity is lowered, and it may be difficult to adapt to the dimensional reliability which is required as the pitch of wire joining is narrowed along with the miniaturization of integrated circuits.

By using the production method of the present invention, the process of the conventional method can be significantly mitigated, and moreover, since the plated laminate (conductive joining material) can be formed directly on the surface of a substrate on which a fine pattern is formed by a plating method, the dimensional reliability is improved. Since the plated laminate and the solder alloy bump have a low melting point of 60 to 110°C, they can be joined by heating and reflowing in a low temperature region of 80 to 135°C, and are suitable for low temperature mounting.

From such a viewpoint, it is preferable to use the production method of the present invention even when producing a joining member having solder alloy bumps. That is, it is preferable to use a plated laminate which includes a laminated plating layer obtained by performing Sn plating, Bi plating, and In plating, and is provided on the surface of the object to be plated.

### [Formation of micro member in which micro core material is coated with plated laminate]

A method for producing a joining member in which a micro core material is a micro member coated with a plated laminate having a composition within the range of the first quadrangle will be described.

When producing a micro member in which a micro core material is coated with a plated laminate, the manufacturing method of the present invention includes a plating step. Specifically, the production method may be performed such that the object to be plated is any micro core material whose size is 1 mm or less, and which is selected from the group consisting of a micro metal ball, a micro resin ball having a coating layer of conductive metal, a micro resin ball having a coating layer of solder alloy, and a micro pin member, and a micro member in which the micro core material is coated with the plated laminate is produced in the plating step.

As a method for plating a micro core material, mention may be made on, for example, a method of performing a plating process at a rotation speed of about 5 to 200 rpm using an apparatus which is provided with a columnar plating tank that rotates in the circumferential direction, and in which an anode is arranged in the center of the plating tank and a cathode is arranged in the circumference of the tank so that vertial rotation with a horizontal rotational axis and tilted rotation with a tilted rotation axis are possible. Specifically, a rotary plating apparatus (barrel plating method) can be used, by which a plating solution and balls, etc. which are an object to be plated, are put in a tank, and the plating process is performed by setting the current density and the energization time so as to obtain a predetermined plating thickness, and when finished, plated balls, etc. and the plating solution are discharged from a rotary circumferential portion. Further, the rotary plating apparatuses which have been improved for plating micro metal balls and described in Japanese Patent Laid-Open No. 10-18096 and Japanese Patent Laid-Open No. 10-270836, and further, the rotary plating apparatus described in Japanese Patent Laid-Open No. 11-92994 can be used.

When forming a Sn-Bi-In-based low melting-point plated laminate on the surface of a micro core material or the like, a known apparatus such as the barrel plating method (the rotary plating apparatus) described above can be used. Each of Sn, Bi, and In may be plated under the same conditions as in the above described plating step. The order of plating lamination is not particularly limited, but it is preferable to perform Sn plating or Bi plating at first (bottom layer), and In plating at the end (top layer). Further, the above described trace metal can be added for the purpose of improving the smoothness and adhesiveness of the plated film, or improving the physical properties such as preventing the balls from aggregating with each other during the plating process.

What described so far is the method for forming the plated laminate according to the present invention on the surface of a micro metal ball, a micro resin ball, a micro pin member, or the like. In the micro members obtained by this method, the melting point of the plated laminate at the surface layer is in a low temperature region of 60 to 110°C. Therefore, the micro member may be used as it is in the mounting process. Further, this may be used in the mounting process as a low melting point solder alloy bump of micro member mounting type.

### [Formation of micro member mounting bump]

When forming a micro member mounting bump, the production method of the present invention includes a plating step, a step of disposing the micro member on a substrate, and a bumping step. The object to be plated is a micro core material. For example, by subjecting the micro member disposed on a conductive joining portion of the substrate to heating and reflowing, it is possible to form a micro member mounting-type bump such as BGA.

An example of bump formation using the above described micro member will be described. For example, a flux is applied on a conductive joining portion such as a printed wiring board for BGA, and the micro member is mounted on the flux. Next, by performing heating and reflowing in the same manner as in the bumping step described above, it is possible to form a micro member mounting bump on the conductive joining portion.

### <Mounting of semiconductor electronic circuit>

The present invention can be related to a method for mounting a semiconductor electronic circuit in which a joining member of the present invention disposed between a wiring substrate and the surface of a semiconductor chip is subjected to heating and reflowing within a range of 80 to 135°C, thereby joining the wiring substrate and the semiconductor chip with the joining member of the present invention. By the method of mounting a semiconductor electronic circuit of the present invention, a semiconductor electronic circuit having the joining member of the present invention can be made.

The heating and reflowing at the time of mounting of a semiconductor electronic circuit can be performed in a reducing atmosphere such as formic acid in the same manner as in the heating and reflowing in the bumping step described above. Conditions such as pressure, heating rate, top temperature, and top temperature holding time may be the same as the conditions for heating and reflowing in the bumping step described above.

As described above, the melting point of the Sn-Bi-In alloy is 60 to 110°C. Therefore, it is possible to mount a semiconductor electronic circuit by performing heating and reflowing in a low temperature region of 80 to 135°C with the semiconductor chip and the wiring substrate being stacked such that the wiring substrate and the surface of the semiconductor chip are in contact with each other via any one selected from the group consisting of a plated laminate made of a Sn-Bi-In alloy, a solder alloy bump made of a Sn-Bi-In alloy, and a micro core material coated with Sn-Bi-In alloy (micro member).

Further, when the melting point of the Sn-Bi-In alloy is about 60°C to 62°C, there may be a concern that the joining strength may decrease or the durability may be insufficient depending on the usage environment. From the viewpoint of joining strength and durability, mounting of a semiconductor electronic circuit may be performed by performing heating and reflowing at 90 to 135°C (top temperature 90 to 135°C) by using a joining member including a Sn-Bi-In alloy having a composition within the range of the third quadrangle and a melting point of 69 to 110°C.

Mounting of a semiconductor electronic circuit is performed, for example, by preparing a semiconductor chip on which a solder alloy bump or a plated laminate is formed, stacking it on an electrode portion for connection of a wiring substrate, and subjecting them to heating and reflowing in a reducing atmosphere such as formic acid to join the both.

A semiconductor chip formed with a pattern of plated laminate or solder alloy bumps is preferably produced by the production method of the present invention using the semiconductor chip as the object to be plated. It is possible to join a semiconductor chip with a wiring substrate by performing heating and reflowing in a reducing atmosphere with the plated laminate or solder alloy bumps patterned on the semiconductor chip and the electrode portions for connection of the wiring substrate being stacked with each other.

The solder alloy bumps and the plated laminate may be formed on the side of the wiring substrate. In that case, an electrode portion for connection is joined to the semiconductor chip side.

The wiring substrate formed with a pattern of the plated laminate or solder alloy bumps is preferably produced by the production method of the present invention with the wiring substrate as the object to be plated. In this case, it is possible to join the semiconductor chip with the wiring substrate by performing heating and reflowing in a reducing atmosphere with the plated laminate or solder alloy bumps patterned on the wiring substrate and the electrode portions for connection of the semiconductor chip being stacked with each other.

The solder alloy bumps and the plated laminate may be formed on both the semiconductor chip side and the wiring substrate side. In such a case, it is possible to join the both by performing heating and reflowing in a reducing atmosphere with the plated laminate or solder alloy bumps patterned on the wiring substrate, and the plated laminate or solder alloy bumps patterned on the semiconductor chip being stacked with each other.

Moreover, a semiconductor chip formed with a pattern of micro member, and a wiring substrate formed with a pattern of micro member may be used.

Further, joining by use of a plated laminate composed of a Sn-Bi-In alloy, a solder alloy bump composed of a Sn-Bi-In alloy, and a micro core material (micro member) coated with a Sn-Bi-In alloy can also be applied to soldering for other than electronic circuit boards such as semiconductor chips and wiring substrates.

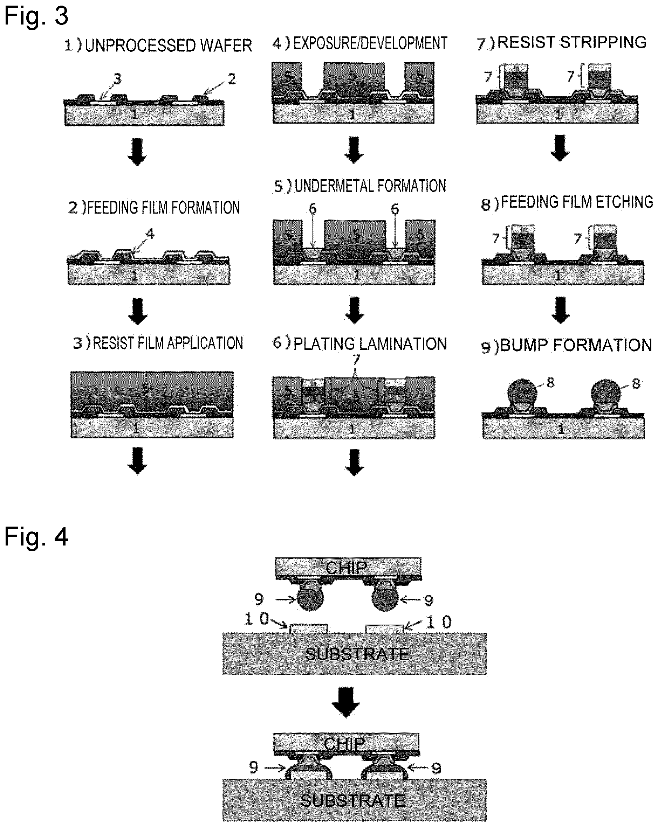

Figure 3 shows a conceptual diagram of the production process of a plated laminate and its solder alloy bumps on the Sn-Bi-In-based low melting-point joining member of the present invention, and Figure 4 shows a conceptual diagram of the mounting thereof as reference.

Figure 3 is an example of a conceptual diagram of the production process up to the formation of a solder alloy bump of the present invention.
1) As shown in unprocessed wafer, first, a pad 3 (Au, Al-Cu, etc.) is disposed on a substrate 1 (silicon, compound semiconductor, a piezoelectric element, a resin substrate, etc.), and a protective film 2 (SiN, polyimide, etc.) is provided.

Next, 2) as shown in feeding film formation, a feeding film 4 (Ti/Cu, etc.) is formed on the protective film 2 and the pad 3.

Next, 3) as shown in resist film application, a resist film 5 is applied on the feeding film 4.

Next, 4) as shown in exposure/development, the resist film 5 is subjected to exposure/development with a predetermined pattern, and a part of the resist film 5 is removed. At this time, usually, the exposure is performed at a position corresponding to the pad 3.

Next, 5) as shown in undermetal formation, an undermetal 6 (Ni, Cu, etc.) is formed in a portion where a hole is formed by performing exposure/development of the resist film 5.

Next, 6) to 9) are performed by the production method of the present invention.

6) As shown in plating lamination, a laminated plating layer 7 (Sn, Bi, In) is formed.

Next, 7) as shown in resist stripping, residual resist film 5 is removed as well. As a result, the laminated plating layer 7 is formed on the pad 3.

Next, 8) as shown in feeding film etching, the feeding film 4 is removed by etching.

Then, 9) as shown in bump formation, as a result of heating and reflowing, a solder alloy bump 8 (Sn/Bi/In) is formed from the laminated plating layer 7, and can be used as the joining member.

Note that the laminated plating layer 7 after the feeding film etching in 8) can be used as it is as the joining member.

Figure 4 is a conceptual diagram showing an example of mounting. By disposing the solder alloy bump 9 so as to be in contact with a metal film 10 (Au) for joining at a corresponding position (see the upper part of Figure 4), and performing heating and reflowing within a range of 80 to 135°C, it is possible to join the wiring substrate with the semiconductor chip (see the lower part of Figure 4).

### Examples

Hereinafter, the present invention will be described in more detail by way of Examples, but the present invention is not limited to the following Examples unless the gist thereof is changed.

### (Composition measurement of plated laminate and solder alloy bump)

Plated laminates obtained in Experimental examples 1 to 46 were peeled off from a SUS substrate, were dissolved in acid, and then quantitatively analyzed by ICP-OES (high frequency inductively coupled plasma-emission spectroscopic analyzer). Further, in Experimental examples 47 to 57, the solder alloy bumps obtained by heating and reflowing the plated laminate were measured in the same manner as described above. The equipment used and measurement conditions were as follows.

Measurement equipment: ICP emission spectroscopic analyzer by Thermo Fisher Scientific Inc., Type: ICAP6300Duo

Measurement conditions: Quantitative analysis by calibration curve method,

Measurement wavelength: Sn 188.9 nm, Bi 306.7 nm, In 325.6 nm

### (Melting point measurement of plated laminate)

An endothermic profile in the heating process was measured using a DSC (Differential Scanning Calorimeter) using the sample obtained by peeling and crushing the plated laminates obtained in Experimental examples 1 to 46 from the SUS substrate as a measurement sample. In the DSC measurement in the heating process, the heat of fusion of each component appears as an endothermic peak, and results in a single or a plurality of endothermic peaks depending on the composition of the measurement sample. In the present invention, for convenience, the top temperature of each endothermic peak was treated as the melting point of the component, and when there were a plurality of peaks, the endothermic peak of the lowest temperature was regarded as the lowest melting point (solidus temperature) and the endothermic peak of the highest temperature was regarded as the highest melting point (liquidus temperature). The equipment used and measurement conditions were as follows.
Measurement equipment: DSC equipment by Seiko Instruments Inc., Type: DSC6220 type
Measurement conditions: Sample amount: 10 to 36 mg Measuring pan: Aluminum
Atmosphere: Nitrogen gas
Measurement temperature range: room temperature to 300°C, Heating rate: 10°C/min

### (Measurement of bump diameter)

Bump diameters of the solder alloy bumps obtained in Experimental examples 47 to 57 were measured by image measurement. The equipment used and measurement conditions were as follows.
Measurement equipment: Laser microscope by KEYENCE CORPORATION, Type: VK-X150
Measurement conditions: Image measurement: Length measurement from 200x image

### (Shear strength measurement of bump)

The shear strength of the solder alloy bumps obtained in Experimental examples 47 to 57 was measured at room temperature (about 20°C) with a shear strength tester. The equipment used and measurement conditions were as follows.
Measurement equipment: Bond tester by Nordson DAGE Inc., Type: 4000
Measurement conditions: Shear speed: 150 µm/S, Shear position: solder part

### [Experimental example 1]

Teflon (registered trademark) tape is attached to the entire back surface of the degreased and cleaned SUS304 plate (100 mm × 40 mm × thickness 0.3 mm), and Teflon (registered trademark) tape is attached to the other surface to form a SUS plate with an opening of 40 mm × 40 mm as the object to be plated. A 1 L beaker made of glass was used as the plating bath, about 500 ml of each plating solution was put therein, and platinum was used for the anode. The following plating solutions were used for each of Sn-Bi-In.
Sn plating solution: manufactured by Ishihara Chemical Co., Ltd. (Sn concentration 5 g/L)
Bi plating solution: manufactured by Ishihara Chemical Co., Ltd. (Bi concentration 40 g/L)
In plating solution: manufactured by EEJA (Electroplating Engineers of Japan) Ltd. (In concentration 25 g/L)

Bi-plating was performed for the first layer. The conditions were as follows: the above described object to be plated was immersed in a Bi plating solution, was subjected to plating while being shaken at a temperature of 20°C and a constant current density of 2 A/dm² for 8 minutes, thereafter being pulled up and immediately immersed in a water tank. This was pulled up and washed with a water shower, and was dried at 50°C for 5 minutes using a ventilation dryer to obtain a Bi-plated product.

Successively, In plating was performed for the second layer. The object to be plated, which had been Bi-plated, was immersed in an In plating solution to be subjected to plating while being shaken at a temperature of 20°C and a constant current density of 3 A/dm² for 5 minutes, thereafter being pulled up and immediately immersed in a water tank. This was pulled up and washed with a water shower, and dried at 50°C for 5 minutes using a ventilation dryer to obtain a Bi-In plated product.

Consecutively, Sn plating was performed for the third layer. The object to be plated, which had been Bi-In plated, was immersed in a Sn plating solution to be subjected to plating while being shaken at a temperature of 20°C and a constant current density of 1 A/dm² for 30 seconds, thereafter being pulled up and immediately immersed in a water tank. This was pulled up and washed with a water shower, and was dried at 50°C for 5 minutes using a ventilation dryer to obtain a plated laminate (Bi-In-Sn plated laminate).

The composition of the sample obtained by stripping the obtained Bi-In-Sn plated laminate from the SUS plate and pulverizing it was measured using an ICP emission spectroscopic analyzer by Thermo Fisher Scientific Inc., and the melting point was measured by using the DSC equipment by Seiko Instruments Inc.

### [Experimental examples 2 to 41]

By the same method as in Experimental example 1, plated laminate samples prepared to have various Sn-Bi-In compositions were made by changing the order of plating lamination, and the plating time of each plating component.

Experimental examples 1 to 12 each have a composition within the ranges of the first, second, and third quadrangles. Experimental examples 13 to 22 each have a composition within the ranges of the first and second quadrangles (outside the range of the composition of the third quadrangle). Experimental examples 23 to 35 each have a composition within the range of the first quadrangle (outside the composition of the second and third quadrangles). Experimental examples 36 to 41 have a composition outside the ranges of the first, second and third quadrangles.

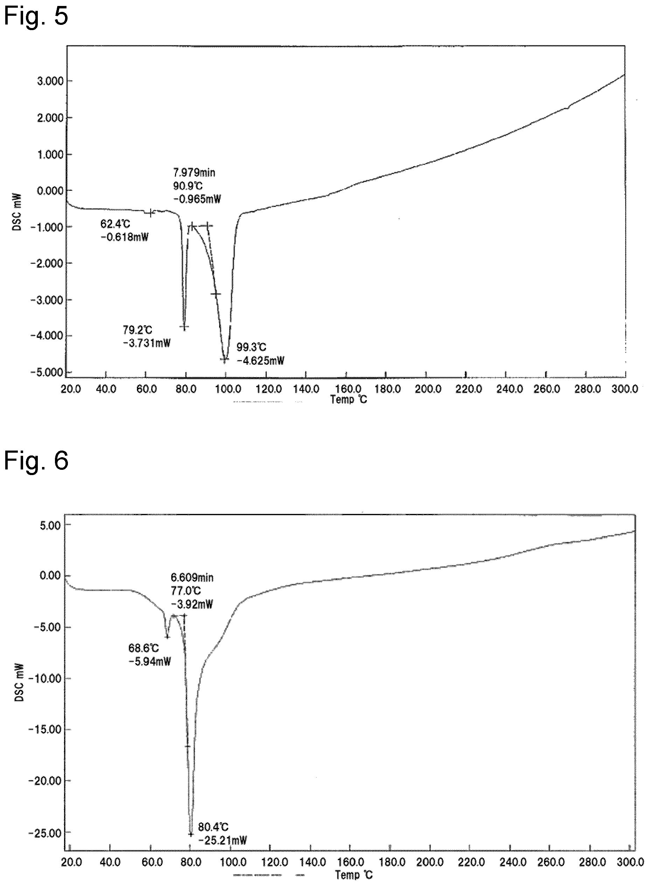

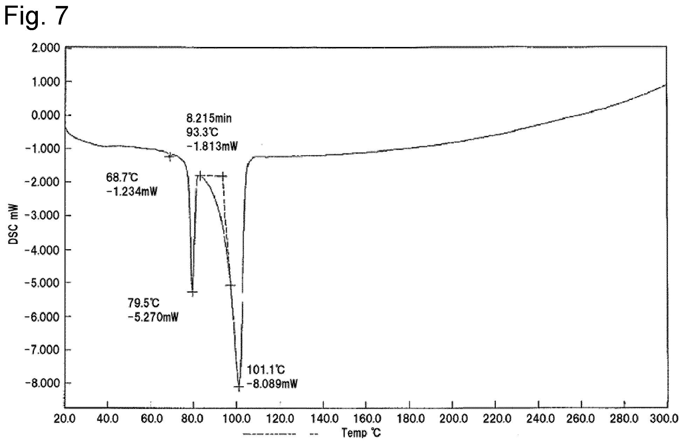

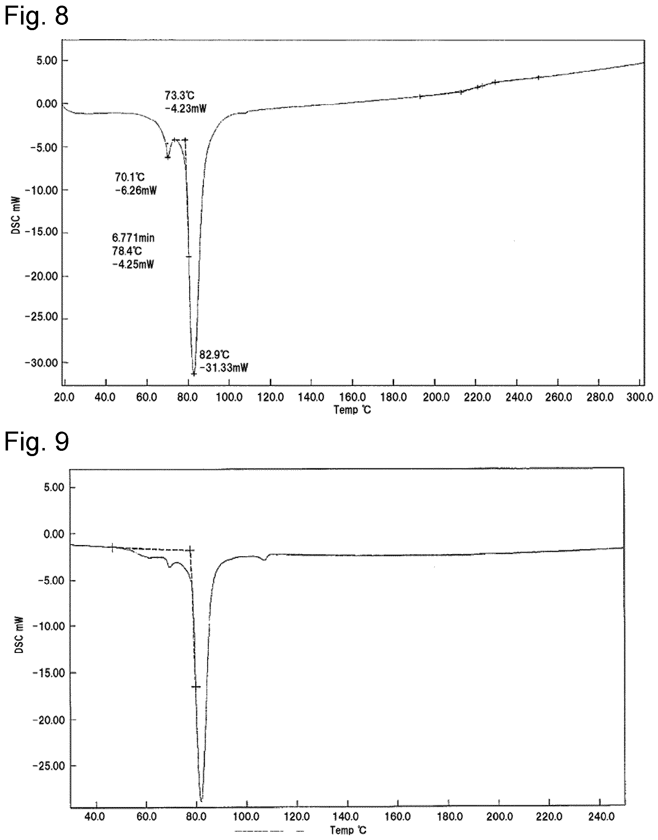

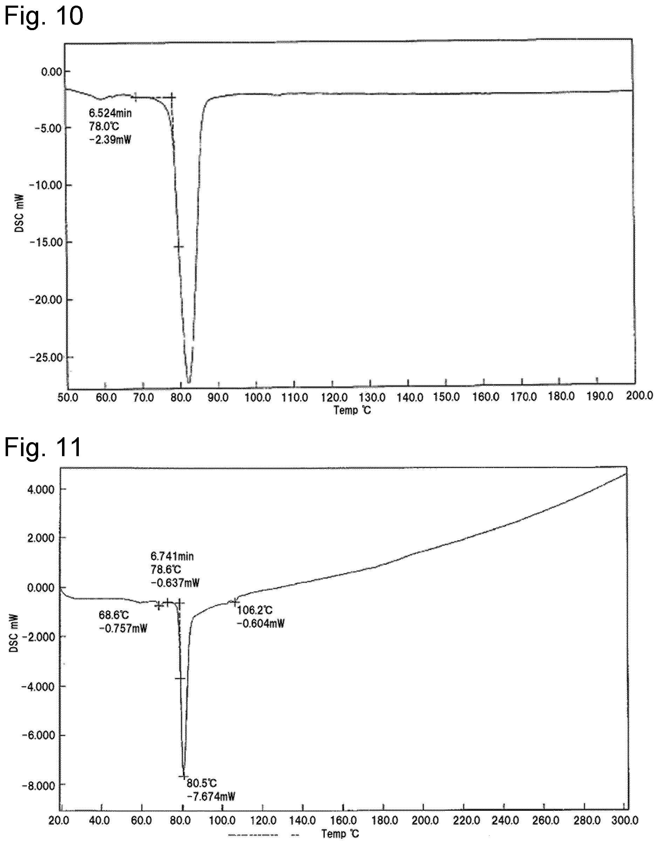

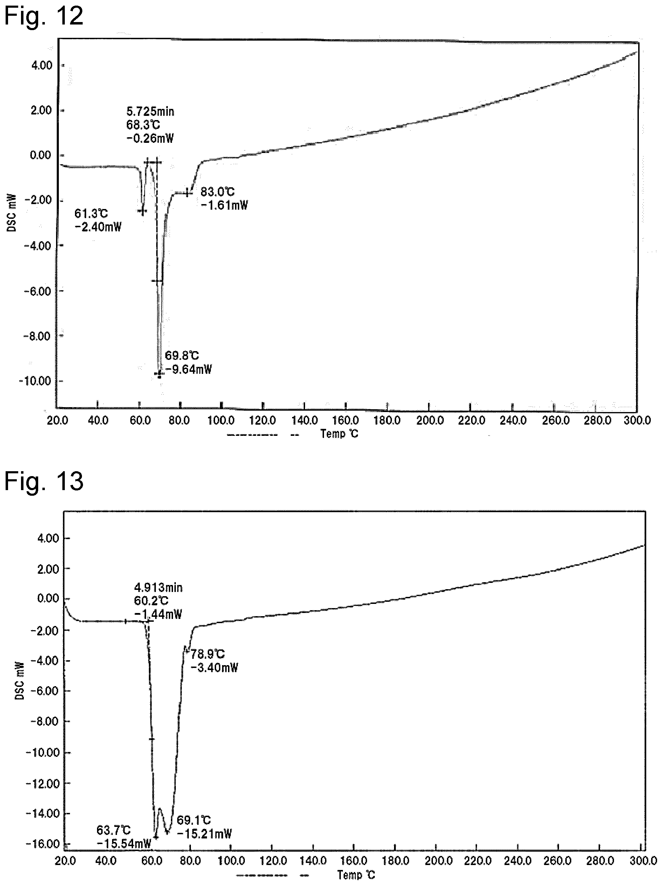

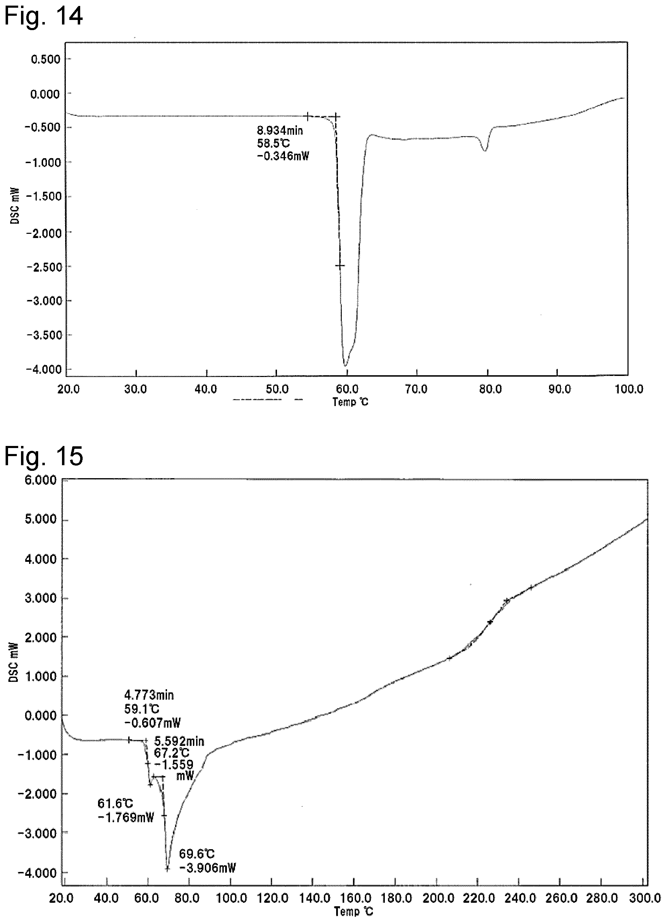

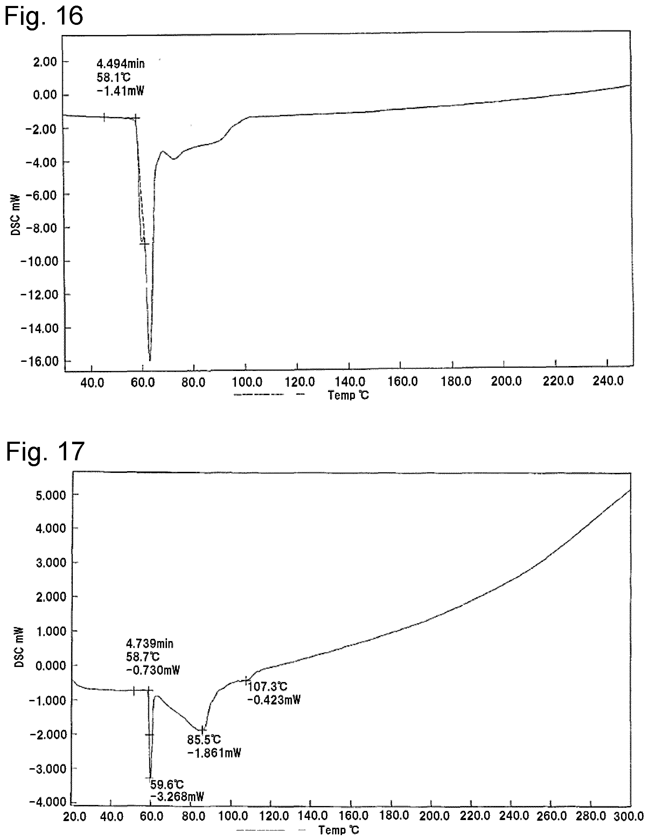

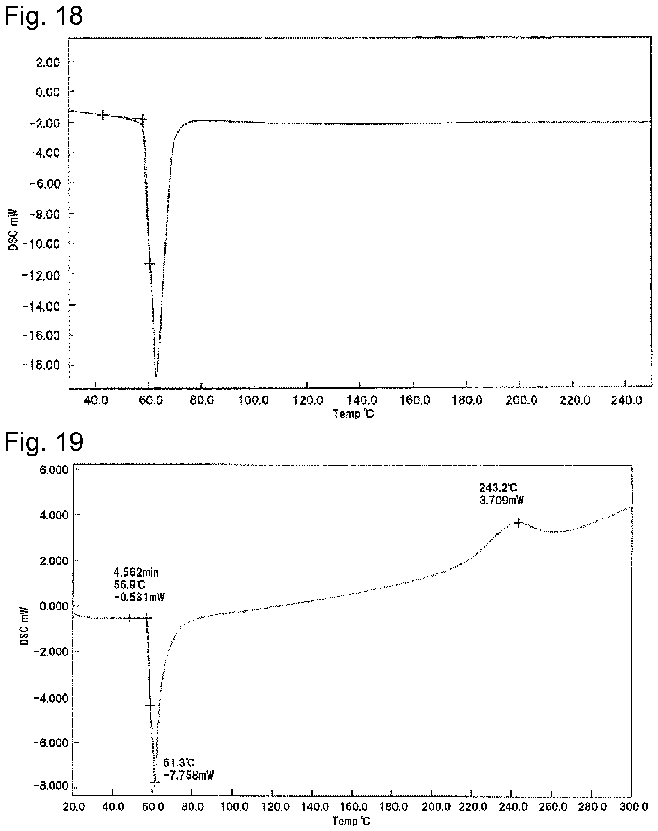

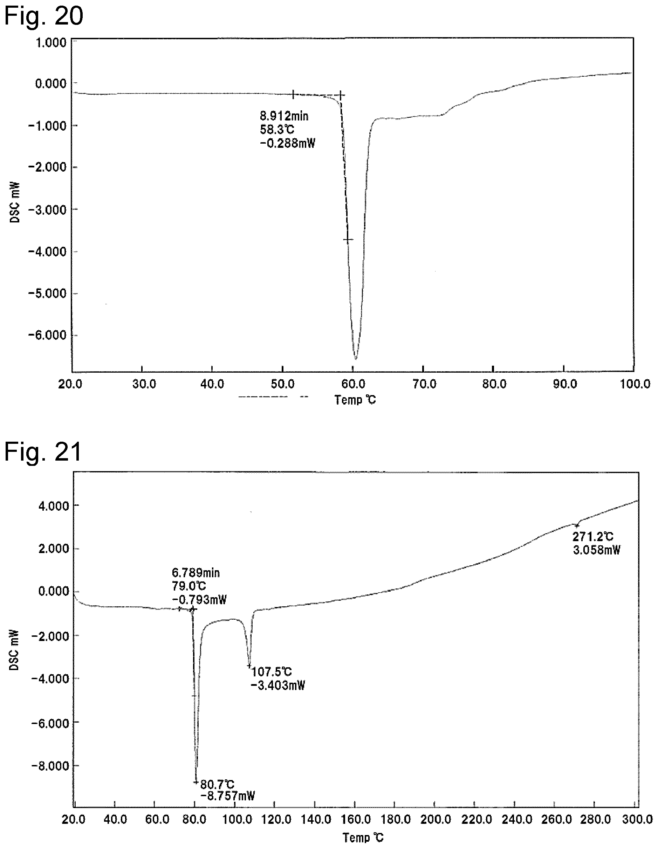

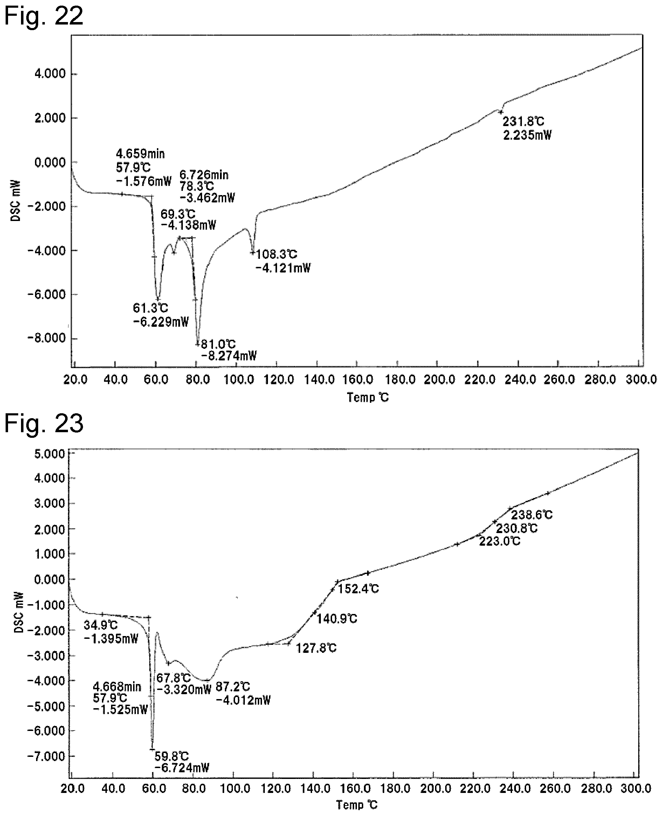

Table 1 (composition analysis and melting point measurement results of plated laminate) shows the composition analysis results and melting point measurement results of the plated laminates obtained in Experimental examples 1 to 41. Further, as typical examples of the DSC chart at the time of melting point measurement, Experimental examples 2, 4, 5, 7, 8, 10, 12, 14, 15, 17, 18, 19, 22, 30, 32, 33, 37, 39 and 41 are shown in Figures 5 to 23.

In the production method of the present invention, a complicated alloy production process can be omitted, and the Sn-Bi-In composition can be arbitrarily controlled by simply changing the plating time (plating liquid immersion time), so that the conventional solder alloy production process can be performed in a remarkably simple and easy manner.

Further, from the results of Experimental examples 1 to 35, it can be seen that the melting point of the plated laminate can be set to a low melting point region of 60 to 110°C by controlling the composition of the plated laminate within a specific range.

On the other hand, in Experimental example 36 to 41 having a composition outside the range of the first quadrangle, it can be seen that the melting point of the plated laminate exceeds 110°C.

For reference, Figure 1 shows a ternary phase diagram of the Sn-Bi-In composition of Experimental examples 1 to 41 and Experimental examples 47 to 53 described later.

From these results, it is judged that when point (x, y, z) is defined as a point where Sn is x mass%, Bi is y mass%, and In is z mass% in the Sn-Bi-In ternary state diagram, a plated laminate having a composition within the range represented by a quadrangle (first quadrangle) having four vertices including: point 1 (1, 69, 30), point 2 (26, 52, 22), point 3 (40, 10, 50), and point 4 (1, 25, 74) can greatly contribute to realization of low temperature mounting of the integrated circuit.

Moreover, as shown in Experimental examples 1 to 12, it has been found that when point (x, y, z) is defined as a point where Sn is x mass%, Bi is y mass%, and In is z mass%, by controlling the composition of plated laminate within a range represented by a quadrangle (third quadrangle) having four vertices including: Point 1 (1,69,30), Point 2 (26,52,22), Point 3a (35,25,40), Point 4b (1,59,40), the plated laminate having a melting point of 69 to 110°C can be obtained, thus enabling to obtain the solder alloy thereof in a low melting point region. Since the melting point is 69°C or more, it has durability even if exposed to use environments of around 60°C.

Note that each composition according to Table 1 (composition analysis and melting point measurement results of plated laminate) may be used as a point for defining a specific range in the ternary phase diagram, and any point may be replaced with Points 1 to 4 as a vertex. Alternatively, the points according to Table 1 can be used to define a range as the vertices of other polygons such as triangles, pentagons, hexagons, heptagons, and octagons.

**[Table 1]**

| Experimental example | Plating lamination order | Plated laminate composition mass% | | | DSC Endothermic peak Top °C | | | |
|---|---|---|---|---|---|---|---|---|
| | | Sn | Bi | In | T1 | T2 | T3 | T4 |
| 1 | Bi→In→Sn | 2 | 65 | 33 | 70 | 78 | 89 | 108 |
| 2 | Bi→In→Sn | 4 | 61 | 35 | 79 | 99 | | |
| 3 | Bi→In→Sn | 15 | 56 | 29 | 69 | 80 | 107 | |
| 4 | Sn→Bi→In | 25 | 51 | 24 | 69 | 80 | 95 | |
| 5 | Bi→In→Sn | 5 | 55 | 40 | 69 | 80 | 101 | |
| 6 | Bi→In→Sn | 11 | 52 | 37 | 69 | 80 | 107 | |
| 7 | Sn→Bi→In | 17 | 51 | 32 | 70 | 83 | | |
| 8 | Sn→Bi→In | 19 | 48 | 33 | 70 | 82 | 108 | |
| 9 | Sn→Bi→In | 11 | 49 | 40 | 70 | 82 | 108 | |
| 10 | Sn→Bi→In | 17 | 45 | 38 | 83 | | | |
| 11 | Sn→Bi→In | 25 | 41 | 34 | 77 | 81 | 100 | |
| 12 | Bi→In→Sn | 29 | 40 | 31 | 69 | 81 | 106 | |
| 13 | Bi→In→Sn | 6 | 51 | 43 | 61 | 69 | 79 | 101 |
| 14 | Bi→In→Sn | 10 | 46 | 44 | 61 | 70 | 83 | |
| 15 | Bi→In→Sn | 17 | 41 | 42 | 64 | 69 | 79 | |
| 16 | In→Sn→Bi | 25 | 32 | 43 | 63 | 72 | 80 | |
| 17 | Sn→In→Bi | 29 | 25 | 46 | 60 | 61 | 80 | |
| 18 | Bi→In→Sn | 32 | 27 | 41 | 62 | 70 | 86 | |
| 19 | Sn→Bi→In | 27 | 26 | 47 | 60 | 63 | 72 | 90 |
| 20 | In→Bi→Sn | 35 | 21 | 44 | 61 | 62 | 75 | |
| 21 | Bi→In→Sn | 31 | 20 | 49 | 60 | 68 | | |
| 22 | Bi→In→Sn | 36 | 15 | 49 | 60 | 86 | 107 | |
| 23 | Bi→In→Sn | 1 | 54 | 45 | 70 | 90 | 109 | |
| 24 | Bi→In→Sn | 1 | 31 | 68 | 72 | 77 | | |
| 25 | Bi→In→Sn | 2 | 29 | 69 | 72 | 78 | | |
| 26 | Bi→In→Sn | 6 | 25 | 69 | 70 | 77 | 80 | |
| 27 | Bi→In→Sn | 9 | 42 | 49 | 62 | 69 | 81 | 107 |
| 28 | Bi→In→Sn | 9 | 40 | 51 | 62 | 69 | 83 | |
| 29 | Bi→In→Sn | 5 | 36 | 59 | 61 | 69 | 82 | 87 |
| 30 | Sn→Bi→In | 16 | 29 | 55 | 62 | | | |
| 31 | Bi→In→Sn | 19 | 31 | 50 | 61 | 67 | 80 | |
| 32 | Bi→In→Sn | 23 | 28 | 49 | 61 | 70 | | |
| 33 | Bi→Sn→In | 29 | 21 | 50 | 60 | 72 | | |
| 34 | Sn→Bi→In | 13 | 22 | 65 | 63 | 70 | 75 | |
| 35 | Sn→Bi→In | 29 | 14 | 57 | 60 | 70 | 80 | 100 |
| 36 | Bi→In→Sn | 9 | 66 | 25 | 67 | 79 | 106 | 271 |
| 37 | Bi→In→Sn | 18 | 61 | 21 | 81 | 108 | 271 | |
| 38 | Bi→In→Sn | 32 | 47 | 21 | 80 | 108 | 136 | 271 |
| 39 | Bi→In→Sn | 40 | 30 | 30 | 61 | 81 | 108 | 232 |
| 40 | Bi→In→Sn | 38 | 24 | 38 | 60 | 64 | 70 | 220 |
| 41 | Sn→Bi→In | 26 | 12 | 62 | 60 | 68 | 87 | 128 |

### [Addition of mixed components (Experimental examples 42 to 46)]

### [Experimental examples 42 to 43]

The same operation as in Experimental example 1 except that Cu was added to the Sn plating solution and plated lamination was performed in the order of SnCu→Bi→In by using a composite plating solution of Sn = 60 g/L and Cu = 1 g/L was performed to obtain a plated laminate added with a trace amount of Cu. The composition of the sample obtained by stripping the plated laminate from the SUS plate and pulverizing it was measured using an ICP emission spectroscopic analyzer by Thermo Fisher Scientific Inc., and the melting point was measured using a DSC apparatus of Seiko Instruments Inc. The results are shown in Table 2 (composition analysis and melting point measurement results of plated laminate added with a trace amount of Cu, Ag).

### [Experimental examples 44 to 46]

The same operation as in Experimental example 1 except that Ag was added to the Sn plating solution, and plated lamination was performed in the order of SnAg→Bi→In using a composite plating solution of Sn = 40 g/L and Ag = 2.5 g/L to obtain a plated laminate added with a trace amount of Ag. The composition of the sample obtained by stripping the plated laminate from the SUS plate and pulverizing it was measured using an ICP emission spectroscopic analyzer by Thermo Fisher Scientific Inc., and the melting point was measured using a DSC apparatus of Seiko Instruments Inc. Results are shown in Table 2.

Experimental examples 42, 45, and 46 each have a composition within the ranges of the first, second, and third quadrangles. Experimental examples 43 and 44 each have a composition within the range of the first quadrangle (outside the range of composition of the second and third quadrangles).

From Experimental examples 42 to 46, it can be seen that the melting point of the plated laminate to which a trace amount of Cu or Ag is added is in a low melting point region of 60 to 107°C, and 110°C or less. From this result, it was confirmed that the Sn-Bi-In-based plated laminate to which a trace amount of Cu or Ag was added can be used as a conductive joining material for low-temperature mounting.

**[Table 2]**

| Experimental example | Plating lamination order | Plated laminate composition mass% | | | | | DSC Endothermic peak Top °C | | | |
|---|---|---|---|---|---|---|---|---|---|---|
| | | Sn | Bi | In | Ag | Cu | T1 | T2 | T3 | T4 |
| 42 | SnCu→Bi→In | 16.3 | 52.7 | 30.5 | | 0.5 | 69 | 81 | 107 | |
| 43 | SnCu→Bi→In | 15.7 | 32.9 | 50.9 | | 0.5 | 62 | | | |
| 44 | SnAg→Bi→In | 15.4 | 35.1 | 48.7 | 0.8 | | 60 | 61 | 67 | 79 |
| 45 | SnAg→Bi→In | 18.7 | 54.4 | 26.0 | 0.9 | | 80 | | | |
| 46 | SnAg→Bi→In | 18.6 | 48.6 | 32.0 | 0.8 | | 69 | 81 | | |

### [Measurement of bump shear strength (Experimental examples 47 to 57]

### [Experimental examples 47 to 53]

A Ti film with a thickness of 0.1 µm and a Cu film with a thickness of 0.3 µm were formed by sputtering on the surface of a silicon wafer with a natural oxide film, to make a silicon wafer on which a resist pattern provided with openings (60 µmφ × height 40 µm: 1000000 pieces, a pitch interval (150 µm)) for wire connection is formed by photolithography. Subsequently, Cu was formed into a film having a thickness of 10 µm by electrolytic plating as a post. Further thereon, a film of Ni was formed in a thickness of 3 µm by electrolytic plating to make a patterned object to be plated.

In Experimental example 47, using the patterned object to be plated, the same operation as in Experimental example 1 except that the plating time (immersion time) in each plating solution was changed in the order of "Bi→Sn→In" such that the plated laminate has a predetermined composition, was performed to make a plated laminate. This was immersed in a resist stripper to remove the resist.

Subsequently, the plated laminate after removing the resist was reflowed under the following conditions using a VSU-200 reflow apparatus manufactured by Shinapex Co., Ltd. to make a solder alloy bump.

Reducing agent: Formic acid
Pressure: 200 mbar
Heating rate: 20°C/min
Top temperature: 110°C (keeping time 180 sec)

In Experimental examples 48 to 53, the same operation as in Experimental example 47 except that the plating time (immersion time) in each plating solution at the time of plated lamination was changed such that the bump composition became a predetermined composition, was performed to make the solder alloy bumps.

Experimental example 47 has a composition within the ranges of the first, second and third quadrangles. Experimental example 48 has a composition within the ranges of the first and second quadrangles (outside the composition range of the third quadrangle). Experimental examples 49 and 50 each have a composition within the range of the first quadrangle (outside the composition of the second and third quadrangles). Experimental examples 51 to 53 each have a composition outside the range of the first, second and third quadrangles.

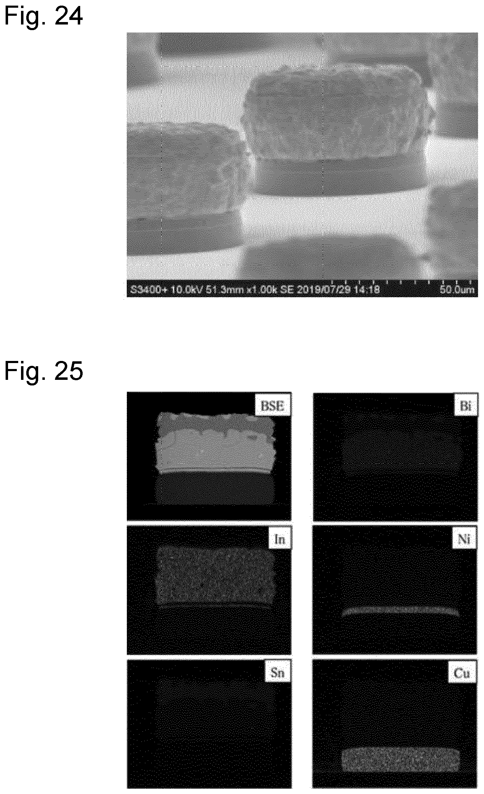

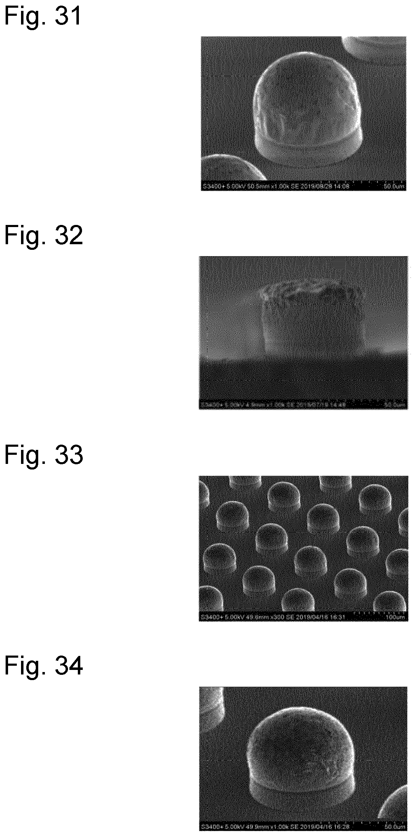

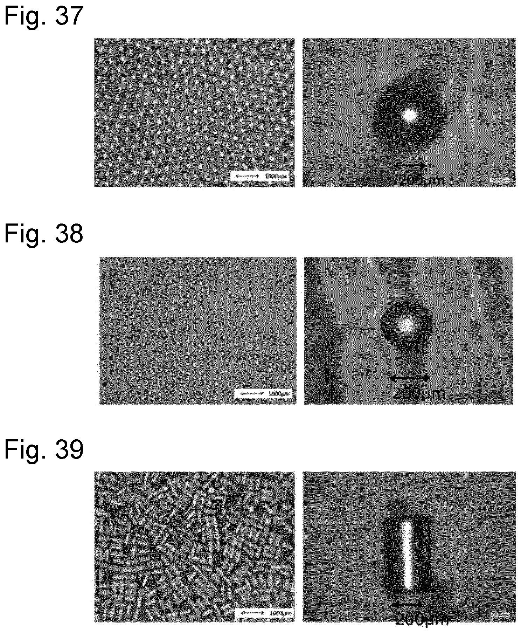

Regarding the shape of the plated laminate, Figure 24 shows an appearance SEM image of the plated laminate after peeling of the resist film of Experimental example 47. Further, the result of SEM-EDX observation of the cross section thereof is shown in Figure 25. Further, Figure 39 shows an appearance SEM image of the plated laminate of Experimental example 48 and Figure 32 shows that of Experimental example 50.

From these figures, it can be seen that a columnar plated laminate corresponding to the resist pattern is formed. Further, from the SEM-EDX sectional image of the plated laminate of Experimental example 47 shown in Figure 25, it was observed that laminated plating was performed in the order of Bi layer → Sn layer on the Cu/Ni undermetal, and In was diffused to these Bi and Sn layers almost uniformly. It is considered that at the stage of plating lamination, In diffused into the lower Sn layer and Bi layer to form alloys of SnIn and BiIn so that the melting point of the final plated laminate was significantly lower than the melting point of Sn, Bi, and In alone. In addition, it is considered that the melting point of the entire plated laminate is lowered even at the heating and reflowing stage.

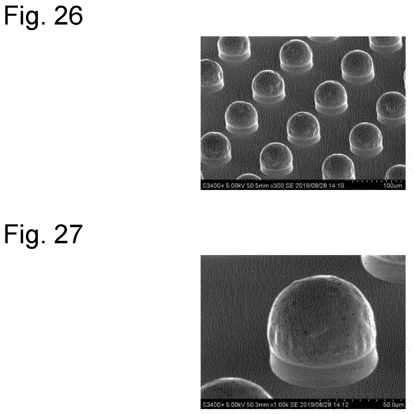

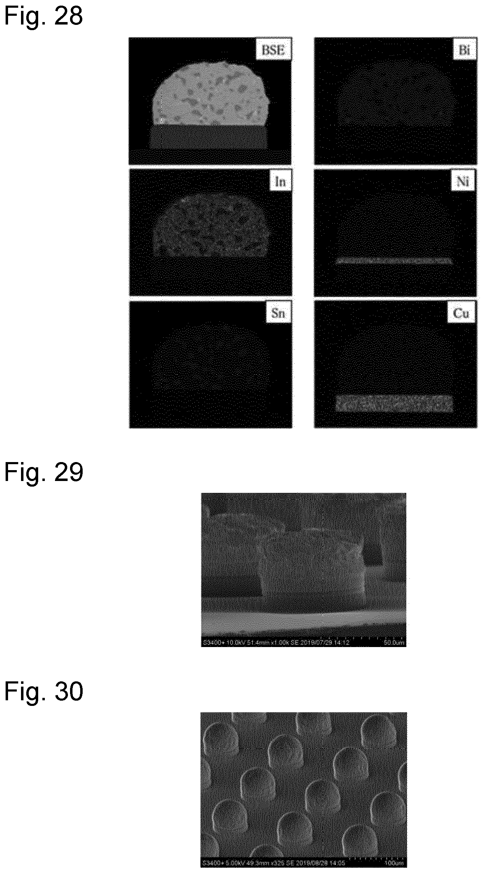

Regarding the formation of solder alloy bumps, Figures 26 and 27 show the appearance SEM images of the bumps of Experimental example 47, Figures 30 and 31 show those of Experimental example 48, and Figures 33 and 34 show those of Experimental example 50. From these figures, it can be seen that hemispherical solder alloy bumps are formed on the Cu/Ni undermetal. Further, Figure 28 shows an SEM-EDX image of the cross section of the bump of Experimental example 47. From this, it was confirmed that a solder alloy bump in which Sn-Bi-In were dispersed almost uniformly was formed by heating and reflowing the plated laminate of each component.

### [Experimental examples 54 to 57]

Experimental examples 54 to 57 are known Pb-free solder alloy bumps produced for the purpose of comparing the bump shear strength with the known Pb-free solder alloy. Using a silicon wafer on which a resist pattern similar to that of Experimental example 47 was formed, a film of the undermetal shown in Table 3 was formed by the same operation (but, in Experimental example 55 and Experimental example 57, formation of a 10 µm Cu post was omitted). Then, on it, SnAg plating was performed using a known SnAg plating solution in Experimental example 54 and Experimental example 55. In Experimental example 56, laminate plating of Sn and Bi was performed using known Sn plating solution and Bi plating solution. In Experimental example 57, In plating was performed using a known In plating solution. After each of these were dried and subjected to the same resist removing operation as in Experimental example 47, solder alloy bumps were made under the same operating conditions except that the reflow temperature shown in Table 3 was set using a similar reflow apparatus.

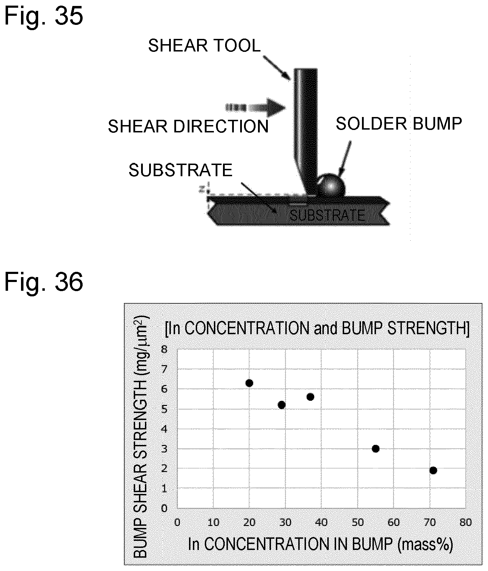

Table 3 (bump composition and shear strength) shows the bump composition and shear strength measurement results of Experimental examples 47 to 57. Note that a plating lamination thickness in the table is a target value for achieving a predetermined composition. For reference, a conceptual diagram of a shear strength tester is shown in Figure 35. Further, Figure 36 shows a "relationship diagram between In concentration and bump shear strength" in which bump shear strength with respect to In concentration of the bumps of Experimental examples 47, and 50 to 53 are plotted.

Considering that among the known Pb-free solder alloy bumps, the indium-only system of Experimental example 57 cannot be put into practical use because of its remarkably low bump shear strength of 0.3 mg/µm², but the bump shear strength of the SnAg system and the Sn58Bi system of Experimental examples 54 to 56, which are usually used as a Pb-free solder alloy, is 3.3 mg/µm², it is seen that the shear strength as a joining member needs to be at least 3.0 mg/µm² or more.

**[Table 3]**

| Experimental example | Undermetal and thickness (Numeral is film thickness: µm) | Plating laminate thickness (µm) | | | Bumping reflow temperature (°C) | Bump composition (mass%) | | | Bump diameter (µm) | Bump shear strength (mg/µm²) |
|---|---|---|---|---|---|---|---|---|---|---|
| | | Sn | Bi | In | | Sn | Bi | In | | |
| 47 | Ti0.1/Cu10.3/Ni3 | 3.8 | 10.0 | 10.0 | 110 | 14 | 49 | 37 | φ60 | 5.6 |
| 48 | Ti0.1/Cu10.3/Ni3 | 8.0 | 5.3 | 12.0 | 110 | 30 | 26 | 44 | φ60 | 6.1 |
| 49 | Ti0.1/Cu10.3/Ni3 | 1.0 | 10.0 | 15.0 | 110 | 3 | 46 | 51 | φ60 | 3.4 |
| 50 | Ti0.1/Cu10.3/Ni3 | 4.4 | 6.8 | 16.7 | 110 | 15 | 30 | 55 | φ60 | 3.0 |
| 51 | Ti0.1/Cu10.3/Ni3 | 3.7 | 4.2 | 21.3 | 110 | 14 | 15 | 71 | φ60 | 1.9 |
| 52 | Ti0.1/Cu10.3/Ni3 | 42.0 | 16.1 | 6.1 | 110 | 15 | 65 | 20 | φ60 | 6.3 |
| 53 | Ti0.1/Cu10.3/Ni3 | 11.2 | 7.4 | 9.1 | 110 | 40 | 31 | 29 | φ60 | 5.2 |
| 54 | Ti0.1/Cu10.3/Ni3 | SnAg: 25.0 | | | 230 | Su2.5Ag | | | φ60 | 3.3 |
| 55 | Ti0.1/Cu0.3/Ni5 | SnAg: 25.0 | | | 230 | Sn3.2Ag | | | φ60 | 3.3 |
| 56 | Ti0.1/Cu10.3/Ni3 | 11.5 | 12.0 | - | 160 | 42 | 58 | - | φ50 | 3.3 |
| 57 | Ti0.1/Cu0.3 | - | - | 10.0 | 180 | - | - | 100 | φ200 | 0.3 |

As shown in Table 3, it has been found that the solder alloy bumps of Experimental examples 47 to 50, which have the composition within the range of the first quadrangle, have sufficient joining strength of the same level as the shear strength of known Pb-free solder alloy bumps (Experimental examples 54 to 56), and therefore can be practically used as a joining material.

As in Experimental examples 47 and 48, it was confirmed that by setting the In concentration to 50 mass% or less (a composition within the range of the second quadrangle), the shear strength of the solder alloy bump was increased to 5.0 mg/µm² or more.

On the other hand, when the In concentration exceeds about 40 mass% as in Experimental examples 48 to 50, the melting point is less than 69°C as in the DSC measurement results of Experimental examples 17, 27 and 30 having compositions similar thereto so that there is a concern that the physical properties as a conductive joining material may deteriorate under normal use temperature environments (maximum 60 to 65°C) of electronic products.

Further, in the case of a composition outside the range of the first quadrangle as in the above described Experimental examples 37 to 41, the melting point will exceed 110°C and cannot be adapted as a low temperature joining material. Similarly, Experimental example 51 is considered to have a melting point at less than 69°C or more than 110°C. In Experimental example 52 (near Experimental example 37) and Experimental example 53 (near Experimental example 39), it is considered that the melting point is increased because endothermic peaks appear near the melting point of Sn or Bi.

### [Micro balls (Experimental examples 58 to 59)]

### [Experimental example 58]

A plated laminate was formed on the surface of a micro metal ball. First, electrolytic Ni plating was performed on the surface of the micro metal ball to form a barrier layer. The surface of a Cu ball of φ 450 µm that had been degreased and washed was subjected to electrolytic Ni plating using a rotary plating apparatus to form a Ni film with a thickness of about 2 µm. The produced Ni-coated Cu ball was used as a micro metal ball (object to be plated).

Subsequently, Bi plating, SnAg plating, and In plating were performed on the micro metal balls using the rotary plating apparatus. The following plating solutions were used.
SnAg plating solution: Manufactured by Ishihara Chemical Co., Ltd. (Sn concentration 5 g/L, Ag concentration 0.5 g/L)
Bi plating solution: Manufactured by Ishihara Chemical Co., Ltd. (Bi concentration 40 g/L)
In plating solution: Manufactured by EEJA Ltd. (In concentration 25 g/L)

Bi-plating was performed for the first layer. The conditions were as follows: the object to be plated was placed in an apparatus containing a Bi plating solution, subjected to plating at a temperature of 20°C, a rotation speed of 178 rpm, and a constant current density of 0.2 A/dm² for 2 hours, thereafter pulled up, and immediately filtered and washed.

This was dried at 50°C for 1 hour using a ventilation dryer to form a Bi-plated product on the surface of the micro metal ball.

Subsequently, SnAg plating was performed for the second layer. The object to be plated, which had been Bi-plated, was placed in an apparatus containing a SnAg plating solution, subjected to plating at a temperature of 20°C, a rotation speed of 178 rpm, and a constant current density of 0.1 A/dm² for 2 hours, thereafter pulled up, and immediately filtered and washed. This was dried at 50°C for 1 hour using a ventilation dryer to form a Bi-SnAg plated product on the surface of the micro metal ball.

Subsequently, In plating was performed for the third layer. The object to be plated, which had been Bi-SnAg-plated, is placed in an apparatus containing an In plating solution, subjected to plating at a temperature of 20°C, a rotation speed of 178 rpm, and a constant current density of 0.1 A/dm² for 6 hours, thereafter pulled up, and immediately filtered and washed. This was dried at 50°C for 1 hour using a ventilation dryer to form a plated laminate (Bi-SnAg-In plated laminate) on the surface of the micro metal ball.

The composition of the sample obtained by dissolving the plated laminate on the surface of the obtained micro metal ball was measured by the ICP emission spectroscopic analyzer by Thermo Fisher Scientific Inc., and the obtained composition was Sn: 16.9 mass%, Bi: 49.2 mass%, In: 33.4 mass%, and Ag: 0.5 mass%. Figure 37 shows an appearance image of the micro metal ball coated with the obtained plated laminate.

### [Experimental example 59]

A plated laminate was formed on the surface of a micro resin ball coated with a conductive metal. First, a film of conductive metal was formed on the surface of the micro resin ball. First, electroless Ni plating was performed on a degreased and washed resin ball having a diameter of φ 210 µm under stirring, and Ni was formed into a film having a thickness of about 1 µm as a conductive layer. Subsequently, electrolytic Cu plating was performed using the rotary plating tank to form a Cu film having a thickness of about 10 µm, and then electrolytic Ni plating was performed to form a Ni film having a thickness of about 1 µm as a barrier layer. The resin ball coated with a conductive metal was used as the object to be plated.

Subsequently, using the rotary plating apparatus, Bi plating, SnAg plating, and In plating were performed on the micro resin ball coated with a conductive metal (object to be plated). The same plating solutions as in Experimental example 58 were used.

Bi plating was performed for the first layer. The conditions were as follows: the above described object to be plated was placed in an apparatus containing a Bi plating solution, subjected to plating at a temperature of 20°C, a rotation speed of 178 rpm, and a constant current density of 0.2 A/dm² for 2 hours, thereafter pulled up, and immediately filtered and washed. This was dried at 50°C for 1 hour using a ventilation dryer to form a Bi plated product on the surface of a resin ball coated with a conductive metal.

Subsequently, SnAg plating was performed for the second layer. The object to be plated, which had been Bi-plated, was placed in an apparatus containing a SnAg plating solution, subjected to plating at a temperature of 20°C, a rotation speed of 178 rpm, and a constant current density of 0.1 A/dm² for 6 hours, thereafter pulled up, and immediately filtered and washed. This was dried at 50°C for 1 hour using a ventilation dryer to form a Bi-SnAg plated product on the surface of a resin ball coated with a conductive metal.

Subsequently, In plating was performed for the third layer. The object to be plated, which had been Bi-SnAg-plated, was placed in an apparatus containing an In plating solution, subjected to plating at a temperature of 20°C, a rotation speed of 178 rpm, and a constant current density of 0.1 A/dm² for 12 hours, thereafter pulled up, and immediately filtered and washed.
This was dried at 50°C for 1 hour using a ventilation dryer to form a plated laminate (Bi-SnAg-In plated laminate) on the surface of a resin ball coated with a conductive metal.

The composition of the sample obtained by dissolving the plated laminate on the surface of the obtained resin ball coated with the conductive metal was measured by the ICP emission spectroscopic analyzer by Thermo Fisher Scientific Inc., and the obtained composition was Sn: 30.0 mass%, Bi: 32.4 mass%, In: 37.4 mass%, and Ag: 0.2 mass%. Figure 38 shows an appearance image of the micro resin ball coated with the obtained plated laminate.

### [Micro metal pin (Experimental example 60]

### [Experimental example 60]

A plated laminate was formed on the surface of the micro metal cylinder. First, electrolytic Ni plating was performed on the surface of a Cu cylinder, which had a diameter of φ 300 µm and a length of L 500 µm and had been degreased and washed, using a rotary plating apparatus, to form a Ni film having a thickness of about 2 µm as a barrier layer. The prepared Ni-coated Cu cylinder was used as a micro metal pin (object to be plated). Subsequently, using a rotary plating apparatus, Bi plating, SnAg plating, and In plating were performed on the micro metal pin. The following plating solutions were used.
SnAg plating solution: Manufactured by Ishihara Chemical Co., Ltd. (Sn concentration 5 g/L, Ag concentration 0.5 g/L)
Bi plating solution: Manufactured by Ishihara Chemical Co., Ltd. (Bi concentration 40 g/L)
In plating solution: Manufactured by EEJA Ltd. (In concentration 25 g/L)

Bi-plating was performed for the first layer. The conditions were as follows: the object to be plated was placed in an apparatus containing a Bi plating solution, subjected to plating at a temperature of 20°C, a rotation speed of 178 rpm, and a constant current density of 0.2 A/dm² for 2 hours, thereafter pulled up, and immediately filtered and washed. This was dried at 50°C for 1 hour using a ventilation dryer to form a Bi-plated product on the surface of the micro metal pin (Cu pin).

Subsequently, SnAg plating was performed for the second layer. The object to be plated, which had been Bi-plated, was placed in an apparatus containing a SnAg plating solution, subjected to plating at a temperature of 20°C, a rotation speed of 178 rpm, and a constant current density of 0.1 A/dm² for 2 hours, thereafter pulled up, and immediately filtered and washed. This was dried at 50°C for 1 hour using a ventilation dryer to form a Bi-SnAg plated product on the surface of the micro metal pin.

Subsequently, In plating was performed for the third layer. The object to be plated, which had been Bi-SnAg-plated, was placed in an apparatus containing an In plating solution, subjected to plating at a temperature of 20°C., a rotation speed of 178 rpm, and a constant current density of 0.1 A/dm² for 6 hours, thereafter pulled up, and immediately filtered and washed. This was dried at 50°C for 1 hour using a ventilation dryer to form a plated laminate (Bi-SnAg-In plated laminate) on the surface of the micro metal pin.

The composition of the sample obtained by dissolving the plated laminate on the surface of the obtained micro metal pin was measured by the ICP emission spectroscopic analyzer by Thermo Fisher Scientific Inc., the obtained composition was Sn: 9.7 mass%, Bi: 51.8 mass%, In: 37.9 mass%, and Ag: 0.6 mass%. Figure 39 shows an appearance image of the micro metal pin coated with the obtained plated laminate.

### Industrial Applicability

The joining member and the production method thereof of the present invention can be suitably used for Pb-free soldering mounting applications of semiconductor electronic components and wiring substrates. In particular, since low-temperature joining is possible, it can be suitably used as a method for low-temperature mounting of electronic components having low heat resistance, such as flexible substrates (resin substrates), piezoelectric elements, CdTe semiconductor elements, CCD elements, and hologram elements.

### Reference signs list

- 1: Substrate
- 2: Protective film
- 3: Pad
- 4: Feeding film
- 5: Resist film
- 6: Undermetal
- 7: Laminated plating layer
- 8: Solder alloy bump
- 9: Solder alloy bump
- 10: Metal film (Au) for joining

## Claims

1. A Sn-Bi-In-based low melting-point joining member, comprising a Sn-Bi-In alloy that has a composition within a range represented by a quadrangle in a Sn-Bi-In ternary phase diagram, the quadrangle having four vertices including: Point 1 (1, 69, 30), Point 2 (26, 52, 22), Point 3 (40, 10, 50), and Point 4 (1, 25, 74), where Point (x, y, z) is defined as a point of x mass% Sn, y mass% Bi, and z mass% In, and that also has a melting point of 60 to 110°C.

2. The Sn-Bi-In-based low melting-point joining member according to claim 1, wherein the Sn-Bi-In alloy has a composition within a range represented by a quadrangle in a Sn-Bi-In ternary phase diagram, the quadrangle having four vertices including: Point 1 (1, 69, 30), Point 2 (26, 52, 22), Point 3 (40, 10, 50), and Point 4a (1, 57, 42), where Point (x, y, z) is defined as a point of x mass% Sn, y mass% Bi and z mass% In.

3. The Sn-Bi-In-based low melting-point joining member according to claim 1 or 2, wherein the Sn-Bi-In alloy has a composition within a range represented by a quadrangle in a Sn-Bi-In ternary phase diagram, the quadrangle having four vertices including: Point 1 (1, 69, 30), Point 2 (26, 52, 22), Point 3a (35, 25, 40), and Point 4b (1, 59, 40), where Point (x, y, z) is defined as a point of x mass% Sn, y mass% Bi and z mass% In, and also has a melting point of 69 to 110°C.

4. The Sn-Bi-In-based low melting-point joining member according to any of claims 1 to 3, wherein the Sn-Bi-In alloy contains one or more mixed components selected from the group consisting of Ag, Cu, Ni, Zn, and Sb, and wherein a total mass of the mixed components in the Sn-Bi-In alloy is 0.001 to 3.0 mass%.

5. The Sn-Bi-In-based low melting-point joining member according to any of claims 1 to 4, wherein the Sn-Bi-In alloy is disposed on a film formed of one or more kinds of undermetal selected, as the undermetal, from the group consisting of Ti, Ni, Cu, Au, Sn, Ag, Cr, Pd, Pt, W, Co, TiW, NiP, NiB, NiCo, and NiV.

6. The Sn-Bi-In-based low melting-point joining member according to any of claims 1 to 5, wherein the Sn-Bi-In alloy has a composition containing Sn: 22 to 30 mass%, Bi: 20 to 28 mass%, and In: 42 to 58 mass%, or Sn: 15 to 19 mass%, Bi: 43 to 51 mass%, and In: 30 to 42 mass%, when a total amount of Sn, Bi, and In is 100 mass%.

7. The Sn-Bi-In-based low melting-point joining member according to any of claims 1 to 6, wherein the Sn-Bi-In alloy has a plated laminate including a plurality of layers having different concentrations of Sn, Bi, and In.

8. The Sn-Bi-In-based low melting-point joining member according to claim 7, wherein the plated laminate includes, at least, a SnIn layer containing Sn and In, and a BiIn layer containing Bi and In.

9. The Sn-Bi-In-based low melting-point joining member according to any of claims 1 to 6, wherein the Sn-Bi-In alloy is a solder alloy bump which is formed by heating and reflowing a plated laminate having a plurality of layers having different concentrations of Sn, Bi, and In.

10. The Sn-Bi-In-based low melting-point joining member according to any of claims 1 to 9, further comprising a micro member having the Sn-Bi-In alloy on a surface of any micro core material selected from the group consisting of a micro metal ball having a size of 1 mm or less, a micro resin ball having a coating layer of conductive metal, a micro resin ball having a coating layer of solder alloy, and a micro pin member.

11. The Sn-Bi-In-based low melting-point joining member according to claim 10, wherein the micro member is mounted on a conductive joining portion.

12. A method for producing a Sn-Bi-In-based low melting-point joining member, comprising a plating step of forming a plated laminate on an object to be plated, the plated laminate including a laminated plating layer obtained by performing Sn plating, Bi plating, and In plating respectively such that the laminated plating layer has a composition within a range represented by a quadrangle in a Sn-Bi-In ternary phase diagram, the quadrangle having four vertices including: Point 1 (1, 69, 30), Point 2 (26, 52, 22), Point 3 (40, 10, 50), and Point 4 (1, 25, 74), where Point (x, y, z) is defined as a point of x mass% Sn, y mass% Bi and z mass% In.

13. The method for producing a Sn-Bi-In-based low melting-point joining member according to claim 12, wherein the object to be plated has a film formed of one or more undermetals selected from the group consisting of Ti, Ni, Cu, Au, Sn, Ag, Cr, Pd, Pt, W, Co, TiW, NiP, NiB, NiCo, and NiV, and the plated laminate is formed on the film.

14. The method for producing a Sn-Bi-In-based low melting-point joining member according to claim 12 or 13, wherein
plating to be first performed on the object to be plated is Sn plating or Bi plating, and the In plating is performed after the Sn plating and the Bi plating are performed.

15. The method for producing a Sn-Bi-In-based low melting-point joining member according to any of claims 12 to 14, wherein
the plated laminate contains one or more mixed components selected from the group consisting of Ag, Cu, Ni, Zn, and Sb, and a total mass of the mixed components in the plated laminate is 0.001 to 3.0 mass%.

16. The method for producing a Sn-Bi-In-based low melting-point joining member according to any of claims 12 to 15, wherein the laminated plating layer is formed such that the Sn-Bi-In alloy has a composition including Sn: 22 to 30 mass%, Bi: 20 to 28 mass%, and In: 42 to 58 mass%, or Sn: 15 to 19 mass%, Bi: 43 to 51 mass%, and In: 30 to 42 mass%, when a total amount of Sn, Bi, and In is 100 mass%.

17. The method for producing a Sn-Bi-In-based low melting-point joining member according to any of claims 12 to 16, wherein
the object to be plated is any micro core material, whose size is 1 mm or less, and which is selected from the group consisting of a micro metal ball, a micro resin ball having a coating layer of a conductive metal, a micro resin ball having a coating layer of a solder alloy, and a micro pin member, and
in the plating step, a micro member in which the micro core material is coated with the plated laminate is produced.

18. A method for producing a Sn-Bi-In-based low melting-point joining member, comprising forming a bump by heating and reflowing a Sn-Bi-In-based low melting-point joining member which is produced by the method for producing a Sn-Bi-In-based low melting-point joining member according to any of claims 12 to 17, and which is disposed on a conductive joining portion.

19. A semiconductor electronic circuit, comprising a Sn-Bi-In-based low melting-point joining member according to any of claims 1 to 11.

20. A method for mounting a semiconductor electronic circuit, comprising
heating and reflowing the Sn-Bi-In-based low melting-point joining member according to any of claims 1 to 11, which is disposed between a wiring substrate and a semiconductor chip surface, in a range of 80 to 135°C, thereby joining the wiring substrate and the semiconductor chip with the Sn-Bi-In-based low melting-point joining member.
